# EUROPÄISCHE PATENTSCHRIFT

(11) **EP 3 117 443 B1**
(45) Veröffentlichungstag und Bekanntmachung des Hinweises auf die Patenterteilung: **01.09.2021**
(21) Anmeldenummer: 14809280.2
(22) Anmeldetag: 12.11.2014
(51) Int. Cl.: H01F 6/00, H01F 7/20, H01F 7/02

(54) **SUPRALEITENDER MAGNETFELDSTABILISATOR**
SUPERCONDUCTIVE MAGNETIC FIELD STABILIZER
STABILISATEUR DE CHAMP MAGNÉTIQUE SUPRACONDUCTEUR

(30) Priorität: 13.03.2014 DE 102014003536
(43) Veröffentlichungstag der Anmeldung: 18.01.2017
(73) Patentinhaber: Forschungszentrum Jülich GmbH, 52425 Jülich (DE)
(72) Erfinder: FALEY, Mikhail, 52428 Jülich (DE); POPPE, Ulrich, 52349 Düren (DE)
(86) Internationale Anmeldenummer: PCT/DE2014/000580
(87) Internationale Veröffentlichungsnummer: WO 2015/135513

(56) Entgegenhaltungen:
- EP-A1- 0 730 284
- EP-A1- 0 819 948
- EP-A2- 0 257 371
- WO-A1-2012/137245
- US-A- 5 329 266
- US-A- 5 448 213
- EASTHAM J F ET AL: "Preliminary investigation of the utility of high temperature superconductor as a means of stabilising a resistive NMR magnet", APPLIED SUPERCONDUCTIVITY, PERGAMON PRESS, EXETER, GB, vol. 1, no. 10-12 1 October 1993 (1993-10-01), pages 1849-1854, XP024174581, ISSN: 0964-1807, DOI: 10.1016/0964-1807(93)90333-W [retrieved on 1993-10-01]

## Beschreibung

Die Erfindung betrifft eine Vorrichtung zur Beaufschlagung eines interessierenden Volumens (VOI) mit einem konstanten Magnetfeld sowie ein Verfahren zum Betreiben.

### Stand der Technik

In vielen Anwendungen, beispielsweise in Elektronenmikroskopen, muss ein begrenztes interessierendes Volumen (Volume of Interest, VOI) mit einem starken, aber zeitlich äußerst konstanten Magnetfeld beaufschlagt werden. Da entsprechend starke Magnetfeldquellen viel Platz beanspruchen, der am Ort des interessierenden Volumens (VOI) regelmäßig nicht zur Verfügung steht, wird mit der Magnetfeldquelle ein magnetischer Fluss in ein magnetisch permeables Joch eingekoppelt und durch dieses Joch in das interessierende Volumen (VOI) geführt. Dieses interessierende Volumen (VOI) ist in der Regel als ein Spalt zwischen als Polschuhe ausgebildeten Regionen des Jochs realisiert. Dort, wo das Joch nicht als Polschuh ausgebildet ist, hat es in der Regel die Form eines Torus.

Verschiedene Störeinflüsse setzen der damit erzielbaren zeitlichen Konstanz des Magnetfelds im interessierenden Volumen (VOI) Grenzen. Wird beispielsweise eine stromdurchflossene Spule als Magnetfeldquelle verwendet, ist die zeitliche Konstanz von vornherein durch die Konstanz der verwendeten Stromquelle für den Strom I begrenzt. Hier ist mit vertretbarem Aufwand nur eine relative Genauigkeit ΔI/I im Bereich 10⁻⁷ bis 10⁻⁸ realisierbar. Das Joch wirkt außerdem nachteilig als Antenne, die die Feldlinien elektromagnetischer oder durch bewegliche magnetische Objekte erzeugter Störfelder auf sich zieht und zusammen mit dem beabsichtigten Feld in das interessierende Volumen (VOI) führt. Weiterhin werden dem durch das Joch übertragenen magnetischen Fluss durch Flusssprünge in dem permeablen (weichmagnetischen) Material statistische Schwankungen (Barkhausen-Rauschen) aufgeprägt. Da die Permeabilität des Jochs temperaturabhängig ist, werden Temperaturschwankungen nachteilig ebenfalls in Schwankungen des Magnetfelds im interessierenden Volumen (VOI) umgewandelt.

Aus dem US-Patent 3,234,435 ist eine supraleitende Ringstruktur zur Stabilisierung des Magnetfelds bekannt, die innerhalb des interessierenden Volumens (VOI) angeordnet ist. Nachteilig wird die Magnetfeldverteilung in dem interessierenden Volumen (VOI) durch die Ringstruktur stark verändert. Weiterhin bewegen sich Flussschläuche in der Ringstruktur, da das Pinning der Flussschläuche in starken Magnetfeldern nur begrenzt effektiv ist. Dies führt zu weiteren Fluktuationen des Magnetfeldes im VOI.

Aus dem US-Patent 5,448,213 ist eine Vorrichtung zur Beaufschlagung eines interessierenden Volumens mit einem konstanten Magnetfeld bekannt, umfassend mindestens eine Magnetfeldquelle und ein permeables Joch, das den von dieser Magnetfeldquelle erzeugten magnetischen Fluss in das interessierende Volumen führt. Das Joch wird hier durch mindestens eine geschlossene, normalleitende Leiterschleife geführt, so dass eine Änderung des Flusses durch das Joch einen dieser Änderung entgegenwirkenden Strom entlang der Leiterschleife bewirkt. Auch hier kann es zu Fluktuationen des Magnetfeldes im VOI kommen. In der US 5,329,266 wird eine Vorrichtung mit supraleitenden Schirmspulen beschrieben, die miteinander kurzgeschlossen sind und um die magnetfelderzeugende Hauptspulen angeordnet sind.

Die WO 2012/137245 zeigt eine Anordnung mit supraleitenden geschlossenen Ringen, die auch von einem supraleitenden Abschirmring umgeben sein können.

Aus der EP 0 730 284 ist ein Transformator bekannt, bei dem Bereiche eines magnetischen Kreises durch in den supraleitenden Zustand überführbare Leiterschleifen, die um ein permeables Joch des magnetischen Kreises angeordnet sind, blockiert bzw. abgeschaltet werden können.

EP 0 257 371 zeigt eine Anordnung eines Elektro-Eisenmagneten mit einem Joch, einer Magnetspule und Induktionsspulen um das Joch, die eine Änderung des Magnetfeldes in dem Joch erfassen und in einem Regelkries für den Spulenstrom der Magnetspule eingebunden sind.

Bei allen nach dem Stand der Technik bekannten Anordnungen kann es jedoch zu Fluktuationen des Magnetfeldes im interessierenden Volumen (VOI) kommen.

Ferner wird verwiesen auf EASTHAM J F ET AL: "Preliminary investigation of the utility of high temperature superconductor as a means of stabilising a resistive NMR magnet", APPLIED SUPERCONDUCTIVITY, PERGAMON PRESS, EXETER, GB, Bd. 1, Nr. 10-12, 1. Oktober 1993 (1993-10-01), Seiten 1849-1854, welches die Merkmale des Oberbegriffs von Anspruch 1 zeigt.

Dokument EP 0 819 948 A1 offenbart einen supraleitenden Jochmagnet für die magnetische Resonanz und eine Methode zu seiner Erregung, wobei eine Magnetfeldquelle aus einem normalleitenden Elektromagneten nahe den Polstücken angeordnet ist und wobei eine Vorrichtung zum Stabilisieren des magnetischen Flusses einen supraleitenden Magneten mit einem Schalter umfasst, der um den ferromagnetischen Flusspfad herum zwischen den Polschuhen angeordnet ist.

### Aufgabe und Lösung

Es ist daher die Aufgabe der Erfindung, eine Vorrichtung zur Verfügung zu stellen, mit der das Magnetfeld im interessierenden Volumen (VOI) ohne Beeinflussung der Feldverteilung stabilisiert werden kann.

Diese Aufgaben werden erfindungsgemäß gelöst durch eine Vorrichtung gemäß Hauptanspruch und durch ein Verfahren zum Betreiben gemäß Nebenanspruch. Weitere vorteilhafte Ausgestaltungen ergeben sich aus den darauf rückbezogenen Unteransprüchen.

### Gegenstand der Erfindung

Im Rahmen der Erfindung wurde eine Vorrichtung zur Beaufschlagung eines interessierenden Volumens (VOI) mit einem konstanten Magnetfeld entwickelt. Diese umfasst mindestens eine Magnetfeldquelle und ein permeables, bevorzugt weichmagnetisches, Joch, das den von dieser Magnetfeldquelle erzeugten magnetischen Fluss in das interessierende Volumen (VOI) führt.

Die Magnetfeldquelle kann dabei insbesondere eine normalleitende oder supraleitende Spule sowie ein Permanentmagnet oder supraleitender Massivkörper mit eingefrorenem magnetischem Fluss sein.

Erfindungsgemäß ist das Joch durch mindestens eine geschlossene, in den supraleitenden Zustand überführbare Leiterschleife geführt, so dass im supraleitenden Zustand der Leiterschleife eine Änderung des Flusses durch das Joch einen dieser Änderung entgegenwirkenden Strom entlang der Leiterschleife bewirkt. Der magnetische Fluss, der durch das Innere der Leiterschleife hindurchtritt, bleibt konstant, solange die Supraleitung aufrechterhalten bleibt.

"Geschlossen" bedeutet im Sinne dieser Erfindung, dass durch eine Änderung des magnetischen Flusses, der durch das Innere der Leiterschleife hindurchtritt, ein dauernder Suprastrom entlang der Leiterschleife induziert werden kann. Jede topologisch geschlossene Form, d.h. jede Form, die durch kontinuierliche Verformung eines Rings mit mindestens einem Loch herstellbar ist, erfüllt diese Bedingung.

Es wurde erkannt, dass sich auf diese Weise der Stabilisator für das Magnetfeld so weit von dem interessierenden Volumen (VOI) beabstanden lässt, dass die Feldverteilung in diesem Volumen praktisch nicht mehr (vernachlässigbar oder nur in sehr geringen Maße) beeinflusst wird. Zugleich wird auch die Qualität der Stabilisierung verbessert, da die Leiterschleife nicht mehr dem vollen, im interessierenden Volumen (VOI) herrschenden Magnetfeld ausgesetzt ist: Befindet sich die Leiterschleife im normalleitenden Zustand, während mit der Magnetfeldquelle (z.B. Spule um das Joch oder Permanentmagnet) der Fluss durch das Joch eingestellt wird, und wird die Leiterschleife erst im Anschluss daran in den supraleitenden Zustand überführt, fließt in ihr zunächst noch kein Suprastrom. Erst wenn unerwünschte Störeinflüsse den Fluss durch das Joch verändern, bewirkt dies einen Suprastrom entlang er Leiterschleife, der dieser Änderung entgegenwirkt. Diese Störeinflüsse machen nur einen sehr kleinen Bruchteil (in höherwertigen Elektronenmikroskopen typischerweise etwa 10⁻⁷ bis 10⁻⁸) des Flusses aus, der durch das Joch zum interessierenden Volumen (VOI) geführt wird und am Ort der Leiterschleife in ihm gefangen ist. Die vergleichsweise geringen Abschirmströme verursachen in der Leiterschleife nur geringe mechanische Kräfte, und Flusssprünge sowie Wanderungen von Flussschläuchen durch nichtideales Pinning werden minimiert.

Es steht der volle kritische Strom, den die Leiterschleife tragen kann, als Regelbereich zur Kompensation von Schwankungen des Flusses zur Verfügung. Bei der Vorrichtung gemäß Stand der Technik befindet sich der Stabilisator dagegen ständig in einem starken Feld, so dass ein deutlich engerer und mit zunehmender Feldstärke immer enger werdender Regelbereich zur Verfügung steht. Gemäß Stand der Technik wird der Wert der konstant zu haltenden Feldstärke eingestellt, indem dieser Regelbereich durch Erhöhung der von außen angelegten Feldstärke bewusst überschritten wird.

Dies ist insbesondere dann wichtig, wenn im Fluss durch das Joch Störungen auftreten, die nicht statistisch um 0 herum schwanken. Störungen mit positivem Vorzeichen erhöhen den Suprastrom durch die Leiterschleife, Störungen mit negativem Vorzeichen verringern ihn. Statistisch um 0 herum schwankende Störungen mitteln sich daher im Zeitverlauf weg, so dass sich in der Leiterschleife per saldo kein Suprastrom anreichert. Gibt es dagegen einen beständigen Störeinfluss, der sein Vorzeichen nicht ändert (etwa eine Drift des Netzteils, das die magnetfelderzeugende Spule mit Strom versorgt), reichert sich ein solcher Suprastrom an. Der Störeinfluss bleibt dann nur so lange ohne Einfluss auf das Magnetfeld im interessierenden Volumen (VOI), bis der kritische Strom durch die Leiterschleife erreicht ist.

Ist bei der erfindungsgemäßen Vorrichtung die Leiterschleife bereits im supraleitenden Zustand, wenn der Fluss mit der Magnetfeldquelle eingestellt wird, manifestiert sich diese Flussänderung nicht unmittelbar im interessierenden Volumen (VOI), sondern wird in dem in der Leiterschleife erzeugten Suprastrom gleichsam zwischengespeichert. Erst wenn die Leiterschleife zumindest kurzzeitig an zumindest einer Stelle in den normalleitenden Zustand versetzt wird, wird der Suprastrom in eine Änderung des Magnetfeldes im interessierenden Volumen (VOI) umgesetzt. Auf diese Weise kann eine Änderung des von der Magnetfeldquelle erzeugten Flusses in eine Änderung der Magnetfeldstärke im interessierenden Volumen (VOI) umgesetzt werden. Wird die Leiterschleife nun wieder in den supraleitenden Zustand zurückgeführt, wird das Feld im interessierenden Volumen (VOI) auf dem neuen Niveau konstant gehalten.

Um das Magnetfeld im VOI schnell ändern zu können, ist es vorteilhaft, die supraleitende Leiterschleife als Dünnfilm auf dünnem Substrat oder aus kommerziellem supraleitendem Bandleiter (z.B. Hastelloy mit hochtemperatursupraleitender (HTSL) Beschichtung) auszuführen. Auf dem supraleitenden Dünnfilm lässt sich lokal eine Querschnittsverengung (Flussdamm), durch die im normalleitenden Zustand ein magnetischer Fluss eindringen kann, und/oder eine lokale Dünnfilmheizung realisieren. Die Leiterschleife kann dann zumindest lokal mit Zeitkonstanten bis hinab in den Millisekunden-Bereich zwischen dem supraleitenden und dem normalleitenden Zustand umgeschaltet werden. Damit kann das Hauptfeld im interessierenden Volumen (VOI) quasi-kontinuierlich verändert werden, wenn dies für die konkrete Anwendung erforderlich ist. Eine möglichst kontinuierliche Feldänderung ist beispielsweise bei der Fokuseinstellung in einem Elektronenmikroskop mit elektromagnetischen Linsen sehr wünschenswert.

Die Erfindung bezieht sich nach dem zuvor Gesagten auch auf Verfahren zum Betreiben der erfindungsgemäßen Vorrichtung, bei denen entweder das Magnetfeld im VOI eingestellt wird, während sich die Leiterschleife im normalleitenden Zustand befindet, oder die Feldänderung zunächst in einen Suprastrom durch die Leiterschleife umgewandelt und später durch Umschalten der Leiterschleife in den normalleitenden Zustand in das VOI übertragen wird.

Im Vergleich zum Stand der Technik nimmt die Erfindung zunächst den scheinbaren Nachteil in Kauf, dass in der Regel zusätzliche Mittel notwendig sind, um die Leiterschleife zwischen dem supraleitenden und dem normalleitenden Zustand hin- und herzuschalten. Dieser Nachteil wird jedoch überkompensiert, indem
- die Feldverteilung im interessierenden Volumen (VOI) nicht mehr beeinflusst wird;
- wesentlich größere Schwankungen des Flusses durch das Joch problemlos ausgeregelt werden können; und
- die im interessierenden Volumen (VOI) nutzbare Feldstärke nicht mehr durch die kritische Feldstärke des für die Leiterschleife verwendeten supraleitenden Materials begrenzt ist.

Wird die Leiterschleife durch Abkühlen unter die Sprungtemperatur vom normalleitenden in den supraleitenden Zustand überführt, so können vorteilhaft auch die Magnetfeldquelle und das Joch gekühlt werden, insbesondere mit dem gleichen Kühlmedium und auf die gleiche Temperatur. Dies ist nicht nur technisch besonders einfach zu realisieren, sondern reduziert zugleich auch das thermische und magnetische Rauschen sowohl in der Magnetfeldquelle als auch im Joch. Weiterhin kann in diesen Fall vorteilhaft eine supraleitende Spule oder ein supraleitender Massivkörper mit eingefrorenen magnetischen Fluss verwendet werden (entspricht einem supraleitenden Permanentmagneten, der durch einen supraleitenden Dauerstrom erzeugt worden ist).

Alternativ kann aber auch nur die Leiterschleife abgekühlt werden. Es muss dann eine geringere thermische Masse abgekühlt werden, was weniger Zeit in Anspruch nimmt, und weder das Joch noch die Magnetfeldquelle werden mit thermischen Zyklen beansprucht. Die Leiterschleife ist dann vorteilhaft thermisch sowohl gegen das Joch als auch gegen die Magnetfeldquelle isoliert.

Die Leiterschleife ist entlang des Jochs zwischen dem Ort, an dem unerwünschte Schwankungen dem Fluss durch das Joch vorwiegend aufgeprägt werden, und dem interessierenden Volumen (VOI) angeordnet. Sind beispielsweise Schwankungen in der Stärke der Magnetfeldquelle, etwa durch eine begrenzte relative Konstanz der Stromversorgung, der begrenzende Faktor für die relative Konstanz des Magnetfelds im interessierenden Volumen (VOI), so reicht eine Leiterschleife aus, die an beliebiger Stelle zwischen der Magnetfeldquelle und dem VOI angeordnet ist. Sie sollte dann lediglich entlang des Jochs so weit von der Magnetfeldquelle entfernt sein, dass gegenseitige Beeinflussungen weitgehend vermieden werden. Vorteilhaft ist daher die Leiterschleife an einem Ort angeordnet, an dem das von der Magnetfeldquelle ausgehende Magnetfeld höchstens ein Zehntel, bevorzugt höchstens ein Hundertstel und ganz besonders bevorzugt höchstens ein Tausendstel seiner maximalen Feldstärke hat.

Rühren Schwankungen des Magnetfelds im VOI dagegen hauptsächlich von Störungen her, die im Joch selbst entstehen (Barkhausen-Rauschen) oder von ihm eingefangen werden, sollte im Bereich eines jeden Übergangs zwischen dem interessierenden Volumen (VOI) und dem Joch, insbesondere überall dort, wo das Joch in eine als Polschuh ausgebildete Region übergeht (etwa durch Verengung seines Querschnitts), eine Leiterschleife angeordnet sein.

Die Leiterschleife kann aber auch einen permeablen, insbesondere weichmagnetischen, Zusatz zu der als Polschuh ausgebildeten Region umschließen, der von dem Polschuh durch einen Spalt beabstandet ist. Der magnetische Fluss tritt dann über den Spalt hinweg vom Polschuh in den Zusatz über. Diese Konstruktion ermöglicht es, die Leiterschleife zusammen mit dem Zusatz zu kühlen, ohne dass sich dies auf den bestehenden Polschuh auswirkt. Der Zusatz kann insbesondere als Flusskonzentrator ausgebildet sein, der den magnetischen Fluss aus dem Polschuh zu einer räumlich eng begrenzten Magnetfeldverteilung im VOI fokussiert.

Vorteilhaft ist das Joch auf jedem von einer Magnetfeldquelle zum interessierenden Volumen (VOI) führenden Weg durch mindestens eine Leiterschleife geführt. Störeinflüsse auf den Fluss, die auf all diesen Wegen in das Joch eingekoppelt werden, schlagen dann nicht mehr auf das interessierende Volumen (VOI) durch, sondern werden in entsprechende Supraströme durch die Leiterschleifen umgewandelt.

Weitere Leiterschleifen vergrößern tendenziell den zur Verfügung stehenden Regelbereich, in dem Störungen im Fluss kompensiert werden. Beispielsweise können in der Nähe der Magnetfeldquelle Leiterschleifen angeordnet sein, die vergleichsweise viel Platz benötigen und dafür einen hohen kritischen Strom tragen können, so dass sie große Störeinflüsse aus dem Netzteil der Magnetfeldquelle zu kompensieren vermögen. In der Nähe des interessierenden Volumens (VOI), wo der Platz deutlich beschränkter ist, können dann kleinere Leiterschleifen angeordnet sein, die nur noch mit den die im Joch selbst entstehenden bzw. von ihm eingefangenen Störungen beaufschlagt werden.

Vorteilhaft ist mindestens eine Leiterschleife an einem Ort entlang des Jochs angeordnet, an dem die vom Joch ausgehende Streufeldstärke höchstens ein Fünftel, bevorzugt höchstens ein Zehntel und ganz besonders bevorzugt höchstens ein Hundertstel der maximalen magnetischen Feldstärke im interessierenden Volumen (VOI) beträgt. Dann ist sichergestellt, dass die Leiterschleife die Feldverteilung im interessierenden Volumen (VOI) besonders wenig beeinflusst. Dies ist insbesondere für elektronenoptische Systeme, etwa Elektronenmikroskope, von Vorteil.

Vorteilhaft weist das Material des Jochs eine relative Permeabilität µᵣ von mindestens 10, bevorzugt von mindestens 100, auf. Die relative Permeabilität µᵣ ist ein dimensionsloser Parameter. Sie gibt im jeweils gewählten Einheitensystem an, um wieviel die Permeabilität größer ist als die des Vakuums. Je größer die relative Permeabilität ist, desto größer ist der von der Magnetfeldquelle ausgehende Fluss Φ, desto größer ist der Anteil dieses Flusses, der in das Joch eingekoppelt wird, und desto weniger von diesem Fluss geht vor dem interessierenden Volumen (VOI) in Form von Streufeldern verloren. Der magnetische Fluss im Joch ist Φ = B*S = µᵣ*µ₀*H_{Feld}*S, wobei B die magnetische Flussdichte, H_{Feld} die lokale magnetische Feldstärke, S die lokale Querschnittsfläche des Jochs und µ₀ = 4*π*10⁻⁷ H/m die magnetische Permeabilität des Vakuums ist. Die Einheit von µ₀ kann in verschiedenen SI-Einheiten ausgedrückt werden: [µ₀] = H/m = N/A² = V*s/(A*m) = T*m/A = T²*m³/J = kg*m/C² = kg*m/(A²*s²), wo die Verwendete Einheiten: H - Henry, m - Meter, V - Volt, s - Sekunde, A - Ampere, T - Tesla, J - Joule, N - Newton, kg - Kilogramm, C - Coulomb sind.

Das Joch muss nicht einstückig gefertigt sein und auch nicht durchgängig aus dem gleichen Material bestehen. Wenn es aus mehreren Teilen besteht, kann der magnetische Fluss beispielsweise über einen Spalt zwischen parallelen Oberflächen der Teile von einem Teil in das andere übertreten. Beispielsweise kann in einem TEM das Joch sowohl Teile der Objektivlinse als auch Teile des Probenhalters umfassen.

Beispielsweise kann das Joch in der Nähe der Magnetfeldquelle eine hohe Sättigungsmagnetisierung und dafür nur eine mäßig hohe relative Permeabilität µᵣ aufweisen. In der Nähe des VOI dagegen, wo der magnetische Fluss durch das Joch auf Grund der Entfernung zur Magnetfeldquelle und der Unterbrechung des Jochs zwecks Bildung des VOI bereits abgenommen hat, kann es eine sehr hohe relative Permeabilität µᵣ von bis zu 100.000 aufweisen im Tausch gegen eine etwas geringere Sättigungsmagnetisierung. Eine hohe Sättigungsmagetisierung einerseits und eine hohe relative Permeabilität µᵣ andererseits sind oft gegenläufige Effekte.

Das Joch kann besonders vorteilhaft zumindest in Teilbereichen eine in Magnetfeldrichtung verlaufende Bohrung aufweisen, durch die ein Licht- oder Teilchenstrahl, insbesondere ein Elektronenstrahl, in Magnetfeldrichtung in das interessierende Volumen (VOI) gerichtet werden kann. Dabei wirkt das lokale inhomogene Streufeld am Austritt der Bohrung als elektromagnetische Linse für den Elektronenstrahl.

Gemäß der Erfindung sind Schaltmittel zur lokalen Umschaltung eines Teils mindestens einer Leiterschleife vom supraleitenden in den normalleitenden Zustand vorgesehen. Dadurch kann der topologisch geschlossene Suprastrom unterbrochen werden, so dass ein magnetischer Fluss in das Innere der Leiterschleife eindringen kann. Eine solche Umschaltung lässt sich in aller Regel deutlich schneller realisieren als ein komplettes Aufwärmen bzw. Abkühlen der Leiterschleife über die Sprungtemperatur hinweg. Die Schaltmittel umfassen vorteilhaft
- mindestens einen Josephson-Kontakt, optional mehrere Josephson-Kontakte (etwa eine SQUID-Struktur) und/oder
- ein Heizelement und/oder
- eine elektromagnetische Strahlungsquelle zur lokalen Erwärmung der Leiterschleife und/oder
- eine lokale Leiterquerschnittsverengung mit reduziertem kritischen Strom auf dem Umfang der Leiterschleife, durch welche beim Übergang in den normalleitenden Zustand ein magnetischer Fluss in die Leiterschleife eindringen kann (Flussdamm)

Ein Josephson-Kontakt lässt sich besonders schnell rein elektromagnetisch (thermisch, magnetisch, mit Mikrowellen, Licht, etc.) zwischen dem normalleitenden und dem supraleitenden Zustand hin- und herschalten. Eine Strahlungsquelle zur lokalen Erwärmung kann insbesondere ein Laser sein.

Wenn die Schaltmittel einen Josephson-Kontakt umfassen, ist der Fluss in der Leiterschleife gezielt einstellbar. Mit Hilfe eines SQUID als Detektor ist es möglich die eindringenden Flussquanten zu zählen. Das Magnetfeld im interessierenden Volumen (VOI) kann dann bis auf einen sehr kleinen (10⁻⁶) Bruchteil eines Flussquants Φ₀ gemessen und über eine Korrekturspule mittels Rückkopplung eingestellt werden.

Vorteilhaft ist mindestens eine Leiterschleife als Schicht auf einem Substrat realisiert, das entweder überhaupt nicht oder erst bei einer tieferen Sprungtemperatur als die Schicht in den supraleitenden Zustand übergeht. Dieses Substrat kann insbesondere wärmeleitfähig sein, und es kann Mittel zum Kühlen unter die Sprungtemperatur der Schicht enthalten. Eine Schicht lässt sich wesentlich schneller abkühlen und wieder erwärmen als eine massive Leiterschleife. Die besonders bevorzugten Hochtemperatursupraleiter, insbesondere keramische auf YBa₂Cu₃O₇₋ₓ(YBCO)-Basis, sind zudem sehr spröde. Eine Schicht auf einem geeigneten, Stabilität verleihenden Substrat kann haltbarer sein als YBCO-Vollmaterial.

Ansonsten ist das grundsätzliche Funktionieren der Vorrichtung an keine bestimmte geometrische Form der Leiterschleife, an keine bestimmte Form ihres Querschnitts und an kein bestimmtes supraleitendes Material gebunden. Die Leiterschleife kann eine beliebige geschlossene Form haben, die das Joch umschließt. Sie kann insbesondere ein Ring, etwa ein flacher Kreisring, oder ein Torus sein. Sie kann aber auch eine Spule sein, deren Anfang und Ende supraleitend verbunden sind, so dass ein Dauerstrom fließen kann. Das Material der Leiterschleife ist vorteilhaft ein Typ II-Supraleiter mit einem hohen kritischen Magnetfeld und einem guten Flusspinning. Es ist bevorzugt ein Hochtemperatursupraleiter (HTSL).

Vorteilhaft sind die Magnetfeldquelle, das Joch und mindestens eine Leiterschleife um eine Achse, die das interessierende Volumen (VOI) durchdringt, rotationssymmetrisch aufgebaut. Vorteilhaft durchdringt diese Achse das interessierende Volumen in Richtung des in dieses Volumen geführten Magnetfeldes. Im interessierenden Volumen (VOI) entsteht dann ein ebenfalls rotationssymmetrisches Feld, das insbesondere für elektronenoptische Systeme, etwa Elektronenmikroskope, nutzbar ist.

Der physikalische Hauptmechanismus, der für die Stabilisierung der Feldstärke im interessierenden Volumen (VOI) maßgeblich ist, ist der Meißner-Ochsenfeld-Effekt. Jede Änderung des magnetischen Flusses durch das Joch stellt einen Versuch dar, das Innere der supraleitenden Leiterschleife mit einem Magnetfeld zu beaufschlagen. Indem ein solches Feld aus dem Inneren herausverdrängt wird, entsteht der Suprastrom durch die Leiterschleife, der der Flussänderung entgegenwirkt. Zusätzlich bewirkt die supraleitende Leiterschleife aber noch, dass der durch sie hindurchtretende Fluss auf eine ganzzahlige Anzahl Flussquanten quantisiert ist und nur jeweils um eine solche ganzzahlige Anzahl geändert werden kann. Die in Elektronenmikroskopen im üblichen Abbildungsmodus verwendeten Flüsse sind so hoch, dass dies in den erzeugten Bildern im Normalfall nicht auffallen wird. Mit gezielt darauf gerichteten Testmessungen lässt sich die Quantisierung jedoch bildlich darstellen. Weiterhin lässt sich die Quantisierung bei Experimenten mit Quantensystemen gezielt ausnutzen. Sie kann auch beispielsweise bei holographischen Experimenten mit Elektronenstrahlen im Elektronenmikroskop zur Analyse von magnetischen Proben eingesetzt werden.

Vorteilhaft ist entlang des Jochs zwischen der Leiterschleife und dem interessierenden Volumen mindestens eine separat mit einem Strom beaufschlagbare Korrekturspule angeordnet. Eine solche Korrekturspule kann bereits mit einem Magnetfeld, das nur etwa 0,1 % der Stärke des Hauptfeldes hat, dessen Fokus merklich verändern. Die Korrekturspule kann aus einem Normalleiter oder - falls sie gekühlt ist - auch aus einem Supraleiter bestehen.

Vorteilhaft sind Mittel zur Messung einer von der Korrekturspule ausgehenden magnetischen Feldstärke sowie eine Rückkoppelschleife vorgesehen, wobei die Rückkoppelschleife die gemessene Feldstärke als Eingabe erhält und den Strom durch die Korrekturspule regelt. Dabei kann der Sensor für diese Messung insbesondere ein SQUID sein. Für dessen Kühlung ist dann in aller Regel kein zusätzlicher Aufwand zu betreiben, da die Kühlung für die Leiterschleife mitbenutzt werden kann. Die Regelung kann insbesondere auf maximale Konstanz der gemessenen Feldstärke erfolgen.

In einer weiteren besonders vorteilhaften Ausgestaltung der Erfindung ist das Joch durch mindestens zwei Leiterschleifen geführt, die entlang des Jochs in einem Abstand zueinander angeordnet sind, der höchstens ihrer Breite entspricht. Der Abstand ist dann mindestens genauso groß wie der kürzeste Abstand, also die minimale Spaltbreite, zwischen der Leiterschleife und dem Joch. In einer weiteren besonders vorteilhaften Ausgestaltung der Erfindung ist die Leiterschleife mindestens so dick wie breit. In einer weiteren vorteilhaften Ausgestaltung der Erfindung weist das Joch eine Ausbuchtung auf, die
- auf der durch den Verlauf der Leiterschleife im Raum definierten Fläche aufliegt und/oder
- durch einen Spalt von dieser Fläche getrennt ist, wobei die Ausbuchtung sich in den Bereich erstreckt, in dem das durch die Leiterschleife erzeugte Magnetfeld mindestens 50 % seiner maximalen Stärke auf der Fläche aufweist.

Diese Ausgestaltungen bewirken, dass das von der oder den Leiterschleifen durch den Suprastrom erzeugte Kompensationsfeld über den Querschnitt der von jeder Leiterschleife umschlossenen Fläche homogenisiert wird. Der durch dieses Feld erzeugte magnetische Fluss durchsetzt dann zu einem größeren Anteil das Joch und trägt zur Kompensation von Flussänderungen im Joch bei. Der Anteil des von einem Suprastrom durch eine Leiterschleife ausgehenden magnetischen Flusses, der durch den Spalt zwischen Leiterschleife und Joch verläuft, ist für die Kompensation verloren. Ist die Leiterschleife eine dünne Schicht und gleichzeitig der Spalt zwischen der Leiterschleife und dem Joch groß, kann dieser Anteil bis zu einem Drittel des insgesamt durch die Leiterschleife hindurchtretenden Flusses betragen.

Nach dem zuvor Gesagten bezieht sich die Erfindung auch auf eine Verwendung der erfindungsgemäßen Vorrichtung
- als magnetische Dipol- oder Multipollinse in einem Elektronenmikroskop,
- zur Stabilisierung eines Magnetfelds, mit dem eine Probe bei einer Messung der kernmagnetischen Resonanz (NMR) beaufschlagt wird,
- zur Stabilisierung eines Magnetfelds in einer Teilchenfalle, insbesondere in einer Ionenfalle, einer Falle für Bose-Einstein-Kondensate oder einer Falle für andere Elementarteilchen, oder
- zur Stabilisierung des Magnetfelds eines Strahlführungs- oder Detektormagneten in einem Teilchenbeschleuniger, insbesondere zum Zweck der Analyse und/oder Formung eines Teilchenstrahls.

### Spezieller Beschreibungsteil

Nachfolgend wird der Gegenstand der Erfindung anhand von Figuren erläutert, ohne dass der Gegenstand der Erfindung hierdurch beschränkt wird. Es ist gezeigt:
- Figur 1:: Magnetische Linse für ein Elektronenmikroskop in Schnittzeichnung.
- Figur 2:: Ausführungsbeispiel der erfindungsgemäßen Vorrichtung in perspektivischer Darstellung.
- Figur 3:: Ausführungsbeispiel mit zwei Magnetfeldquellen und zwei supraleitenden Leiterschleifen in perspektivischer Darstellung.
- Figur 4:: Zum interessierenden Volumen (VOI) hin spitz zulaufende Linse für ein Elektronenmikroskop in Schnittzeichnung.
- Figur 5:: Magnetische Linse für ein Transmissionselektronenmikroskop in Schnittzeichnung.
- Figur 6:: Magnetische Linse für ein Transmissionselektronenmikroskop mit dreiteiligem weichmagnetischem Joch und Integration der supraleitenden Leiterschleife in den Probenhalter, in Schnittzeichnung.
- Figur 7:: Quadrupolmagnet als Ausführungsbeispiel der erfindungsgemäßen Vorrichtung in Schnittzeichnung.
- Figur 8:: Linse für ein Transmissionselektronenmikroskop mit Magnetfelddetektor und Rücckopplungsspulen als Ausführungsbeispiel der erfindungsgemäßen Vorrichtung in Schnittzeichnung.
- Figur 9:: Versuchsaufbau für eine "Proof of Concept"-Messung zur Demonstration des Grundprinzips.
- Figur 10:: Oszilloskop-Aufzeichnungen der "Proof of Concept"-Messung: a) Leiterschleife ist im supraleitenden Zustand und b) Leiterschleife ist im normalleitenden Zustand.
- Figur 11:: Verteilung des Magnetfeldes H zwischen supraleitender Leiterschleife und Permalloy Joch im Fall: a) einer Dünnschicht-Leiterschleife, b) mehrerer DünnschichtLeiterschleifen oder c) einer massiven Leiterschleife.

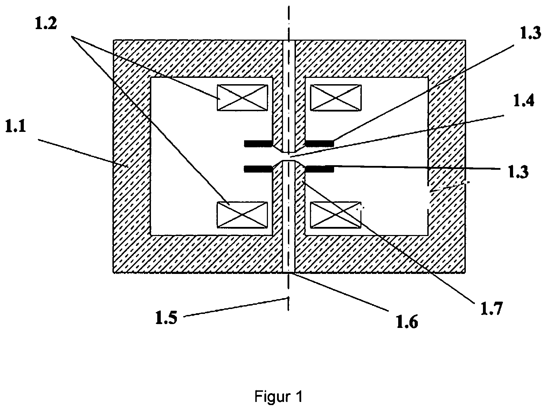

Figur 1 zeigt eine magnetische Linse für ein Elektronenmikroskop als Ausführungsbeispiel der erfindungsgemäßen Vorrichtung in Schnittzeichnung. Die Linse ist in dem Elektronenmikroskop beispielsweise als Objektivlinse, Korrekturlinse oder Kondensorlinse verwendbar. Ein durch normalleitende oder supraleitende Spulen 1.2 als Magnetfeldquelle erzeugter magnetischer Fluss wird durch ein weichmagnetisches Joch 1.1 in das interessierende Volumen (VOI) 1.4, welches als Elektronenstrahllinse wirkt, geführt. In der Nähe dieses Volumens befindet sich im Betrieb des Elektronenmikroskops die Probe, die mit dem Elektronenstrahl abgebildet wird. Der Elektronenstrahl kann entlang der Symmetrieachse 1.5 durch die in Magnetfeldrichtung durch das Joch verlaufende Bohrung 1.6 in das interessierende Volumen (VOI) geführt werden. Dieses Ausführungsbeispiel ist rotationssymmetrisch um die Symmetrieachse 1.5.

Die erfindungsgemäß vorgesehene supraleitende Leiterschleife 1.3 umschließt den Teil 1.7 des Jochs 1.1. An diesem Ort beeinflussen die Leiterschleife 1.3 und die normalleitenden oder supraleitenden Spulen 1.2 sich gegenseitig nur geringfügig (vernachlässigbar). Zugleich befindet sich die Leiterschleife 1.3 auch noch außerhalb des magnetischen Streufelds, das im vordersten Bereich des Teils 1.7 des Jochs entsteht. Dieser vorderste Bereich ist ausgehend von einer Torusform als Polschuh ausgebildet und läuft zu diesem Zweck durch eine konische Querschnittsverengung auf das interessierende Volumen (VOI) 1.4 zu.

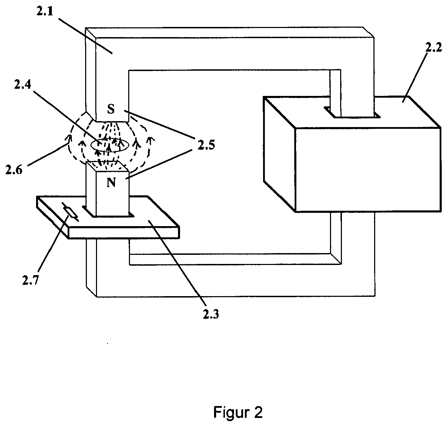

Figur 2 zeigt ein weiteres Ausführungsbeispiel der erfindungsgemäßen Vorrichtung in perspektivischer Darstellung. Das weichmagnetische Joch 2.1 hat eine zum Rechteck gebogene Form. Durch eine normalleitende Spule 2.2 als Magnetfeldquelle wird ein magnetischer Fluss in dieses Joch 2.1 eingekoppelt. Das Joch 2.1 führt diesen Fluss in das interessierende Volumen (VOI) 2.4. Dieses Volumen VOI wurde gebildet, indem das Joch 2.1 durch einen Spalt unterbrochen wurde. Der durch eine Spule 2.2 erzeugte magnetische Fluss Φ wird durch das Joch 2.1 zu den Rändern des Spalts geführt, welche durch die Polschuhe 2.5 gegeben sind. Die Polschuhe bilden einen magnetischen Nordpol (N) und einen magnetischen Südpol (S). Der magnetische Fluss beaufschlagt das Volumen VOI 2.4 mit einem Magnetfeld. Einige der Feldlinien 2.6 dieses Feldes sind zur Illustration in das VOI 2.4 eingezeichnet.

Die Stärke des Magnetfelds in der VOI 2.4 wird durch den magnetischen Fluss durch das Joch 2.1 bestimmt. Das Joch 2.1 ist in der Nähe des Polschuhs 2.5, der den Nordpol bildet, von der supraleitenden Leiterschleife 2.3 umschlossen. Nachdem mit der normalleitenden Spule 2.2 das Magnetfeld im Volumen VOI 2.4 eingestellt wurde, wird diese Leiterschleife 2.3 unter ihre Sprungtemperatur gekühlt und somit in den supraleitenden Zustand versetzt. Änderungen des magnetischen Flusses 2.6 durch das Joch 2.1 werden fortan durch Induzierung eines Suprastroms entlang der Leiterschleife 2.3 kompensiert. Auf der supraleitenden Leiterschleife befindet sich ein Heizelement 2.7. Dieses erlaubt es die Leiterschleife wieder in normalleitenden Zustand zu versetzen, um gegebenenfalls einer Änderung des magnetischen Flusses im VOI 2.4 vornehmen zu können.

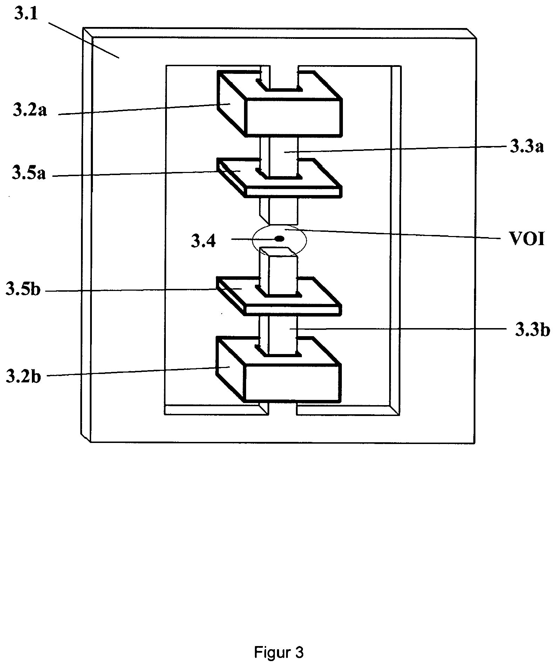

Figur 3 zeigt ein weiteres Ausführungsbeispiel der erfindungsgemäßen Vorrichtung in perspektivischer Darstellung. In das weichmagnetische Joch 3.1 wird durch zwei normalleitende Spulen 3.2a und 3.2b ein magnetischer Fluss eingekoppelt und zum interessierenden Volumen (VOI) geführt. Das VOI befindet sich in einem Spalt, durch den das Joch 3.1 unterbrochen ist. Die Übergänge des Jochs 3.1 zu diesem Spalt sind jeweils als Polschuhe 3.3a und 3.3b ausgebildet, die auf das VOI wie ein magnetischer Nord- bzw. Südpol wirken.

In der Nähe der Polschuhe 3.3a und 3.3b ist das Joch 3.1 jeweils durch die supraleitenden Ringe 3.5a und 3.5b geführt. Diese sind jeweils als dünne supraleitende Schicht auf einem toroidalen, nicht supraleitenden Substrat realisiert. Unabhängig davon, an welcher Stelle dem magnetischen Fluss durch das Joch 3.1 Störeinflüsse aufgeprägt werden, werden diese in Flussänderungen kompensierende Supraströme durch die Ringe 3.5a und 3.5b umgewandelt, so dass der Fluss durch das Joch 3.1 und damit auch das Feld im VOI nahezu konstant bleiben. Eine Probe 3.4 kann mittig zwischen den Polschuhen angeordnet werden.

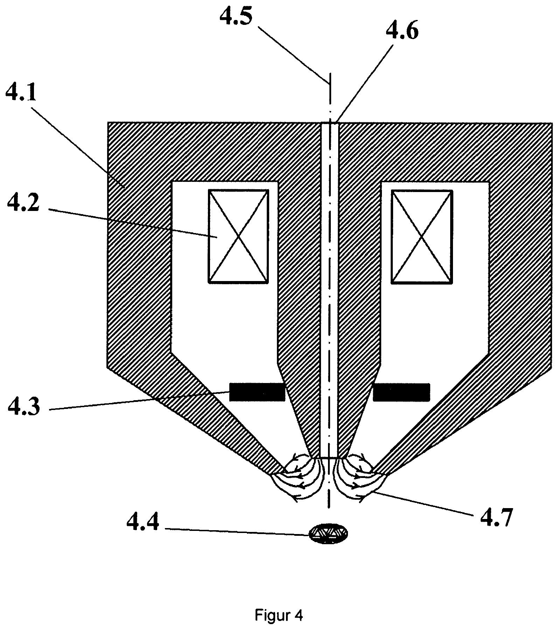

Figur 4 zeigt eine weitere rotationssymmetrische Linse für ein Elektronenmikroskop als Ausführungsbeispiel der erfindungsgemäßen Vorrichtung in Schnittzeichnung. Eine Spule 4.2 koppelt einen magnetischen Fluss in das weichmagnetische Joch 4.1 ein. Dieses Joch läuft zum interessierenden Volumen (VOI) 4.7 hin spitz zu. Das interessierende Volumen (VOI) 4.7 wirkt als Linse für die Elektronstrahl. Der Elektronenstrahl wird beim Passieren des als Linse wirkenden VOI 4.7 auf eine im Arbeitsabstand zu der Linse angeordnete Probe 4.4 fokussiert. Wo das Joch beginnt, spitz zuzulaufen, ist sein mittlerer Teil durch eine supraleitende Leiterschleife 4.3 geführt. Dies ist eine supraleitende geschlossene Spule oder eine ringförmige Dünnschicht auf einem kühlbaren Substrat. Die Linse ist rotationssymmetrisch um eine Achse 4.5, die in Richtung des magnetischen Hauptfelds durch eine Bohrung 4.6 in der Linse zum VOI führt.

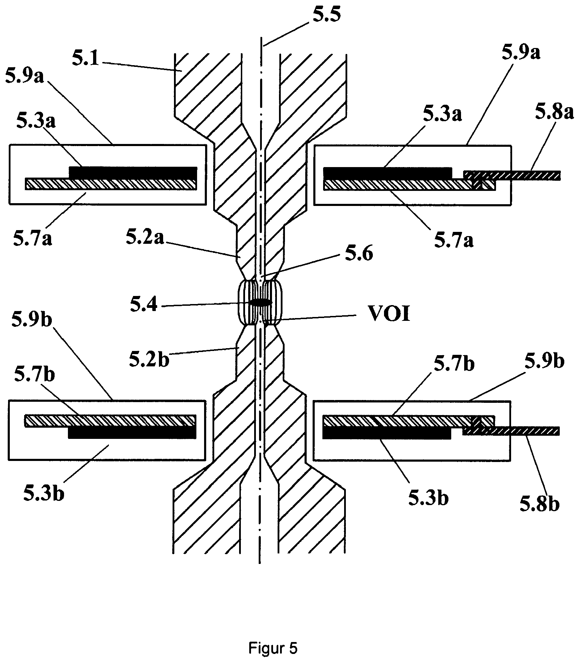

Figur 5 zeigt eine Linse für ein Transmissionselektronenmikroskop als Ausführungsbeispiel der erfindungsgemäßen Vorrichtung in Schnittzeichnung. Die Linse ist insbesondere als Objektivlinse verwendbar. Der Teil des weichmagnetischen Jochs 5.1, in dem es von einer Magnetfeldquelle mit einem magnetischen Fluss durchsetzt wird, ist in Figur 5 nicht eingezeichnet. Dargestellt ist nur der Teil des Jochs 5.1, in dem dieses durch konisches Zulaufen in Polschuhe 5.2a und 5.2b übergeht, die das interessierende Volumen VOI begrenzen. Beide Polschuhe 5.2a und 5.2b sind jeweils mit einer Bohrung 5.6 versehen, durch die der Elektronenstrahl in das VOI, zur Probe 5.4 und von dort zu dem in Figur 5 nicht eingezeichneten Detektor geführt werden kann. Zwischen den Polschuhen 5.2a und 5.2b herrscht ein inhomogenes Magnetfeld, das in unmittelbarer Nähe des Austritts aus der Bohrung 5.6 als Linse wirkt; einige der Feldlinien sind zur Illustration eingezeichnet. Die Linsenwirkung kommt durch die starke Krümmung der Feldlinien im Bereich der Bohrung 5.6 zu Stande. Dieser Bereich ist das interessierende Volumen (VOI), denn die Abbildungsqualität der Linse hängt davon ab, wie gut das Magnetfeld gerade hier bezüglich zeitlichen und räumlichen Schwankungen sowohl seiner Stärke als auch seiner Geometrie stabilisiert ist. Insbesondere muss die als Linse wirkende starke Krümmung der Feldlinien erhalten bleiben.

Die Probe 5.4 befindet sich im Magnetfeld zwischen den Polschuhen 5.2a und 5.2b, jedoch im Arbeitsabstand zum als Linse wirkenden VOI und ist dort auf einem nicht eingezeichneten Probenhalter fixiert. Durch beide Bohrungen 5.6 und das interessierende Volumen VOI verläuft die Symmetrieachse 5.5, um die die Linse rotationssymmetrisch ist.

Die beiden Polschuhe 5.1 bzw. 5.2a und 5.2b sind durch flache supraleitende Ringe 5.3a und 5.3b aus dem Hochtemperatursupraleiter YBCO geführt. Diese Ringe können beispielweise als Dünnschicht auf einem Substrat aufgebracht sein. Die supraleitenden Ringe sind auf die Träger (Kühlfinger) 5.7a und 5.7b zum Beispiel aus Kupfer befestigt, welche durch thermische Verbindungen 5.8a und 5.8b mit einem nichtgezeigten Kühlreservoir auf der Arbeitstemperatur verbunden sind.

Nachdem mit der Magnetfeldquelle das gewünschte Magnetfeld im VOI eingestellt wurde, werden die Kühlfinger 5.7a und 5.7b mittels der wärmeleitenden Verbindungen 5.8a und 5.8b abgekühlt und kühlen ihrerseits die Ringe 5.3a und 5.3b unter ihre Sprungtemperatur. Fortan bleibt das Magnetfeld im VOI konstant. Soll die Magnetfeldstärke geändert werden, können hierfür die Ringe 5.3a und 5.3b mit Heizern zumindest lokal kurzzeitig über die Sprungtemperatur erwärmt und damit normalleitend gemacht werden.

Die Leiterschleifen können unabhängig von den Polschuhen des Elektronenmikroskops, die auf Raumtemperatur verbleiben können, mittels der wärmeleitenden Verbindungen 5.8a und 5.8b separat unter ihre Sprungtemperatur gekühlt bzw. mit mindestens einem Heizer zurück über die Sprungtemperatur erwärmt werden. In einem Elektronenmikroskop befinden sich sowohl die Polschuhe 5.2a und 5.2b als auch die Anordnung aus Leiterschleife 5.3a und 5.3b und Kühlfinger 5.7a und 5.7b in einem Hochvakuum, das als thermische Isolierung wirkt. Durch die zusätzlichen thermischen Schilde 5.9a und 5.9b, etwa eine reflektierende Folie, können Leiterschleife 5.3a und 5.3b und Kühlfinger 5.7a und 5.7b zusätzlich gegen die Polschuhe 5.2a und 5.2b thermisch isoliert werden.

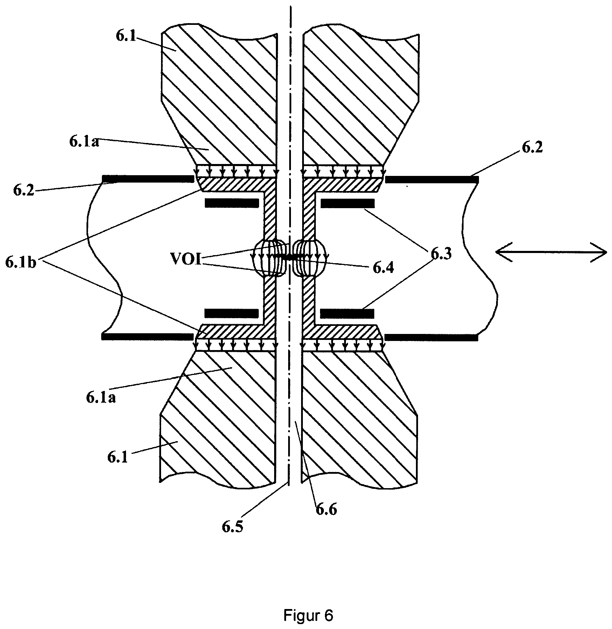

Figur 6 zeigt eine weitere Linse für ein Transmissionselektronenmikroskop als Ausführungsbeispiel der erfindungsgemäßen Vorrichtung in Schnittzeichnung. Auch in Figur 6 ist die Magnetfeldquelle aus Gründen der Übersichtlichkeit nicht eingezeichnet. Das weichmagnetische Joch 6.1 besteht aus einem Grundkörper 6.1a und zwei Konzentratoren 6.1b, die als Polschuhe ausgebildet sind. Der Grundkörper 6.1a kann beispielsweise die Polschuhe eines bestehenden Elektronenmikroskops umfassen. Die Konzentratoren 6.1b sind so zum Grundkörper 6.1a angeordnet, dass sich plane Flächen gegenüberliegen und der magnetische Fluss aus dem Grundkörper 6.1a im Wesentlichen verlustfrei in die Konzentratoren 6.1b eintreten kann. Das interessierende Volumen VOI befindet sich dort, wo die beiden Konzentratoren 6.1b sich am nächsten gegenüberstehen. In diesem Volumen herrscht ein inhomogenes, als Linse wirkendes Magnetfeld, in dem sich die Probe 6.4 befindet.

Die Konzentratoren sind durch supraleitende Ringe 6.3 aus YBCO geführt. Die Konzentratoren 6.1b und die Leiterschleifen 6.3 sind gemeinsam in einen Probenhalter 6.2 für die Probe 6.4 integriert, der unabhängig von den sonstigen Komponenten des Elektronenmikroskops gekühlt werden kann. Auf diese Weise ist die Vorrichtung besonders einfach durch Einschieben dieses Probenhalters 6.2 in ein ansonsten nicht modifiziertes Elektronenmikroskop integrierbar.

Die Linse ist rotationssymmetrisch zu einer Achse, die in Richtung des Hauptfelds durch das interessierende Volumen VOI führt. Diese Achse 6.5 entspricht beim Betrieb des Elektronenmikroskops der Strahlachse des Elektronenstrahls. Sowohl der Grundkörper 6.1a als auch die Konzentratoren 6.1b weisen jeweils Bohrungen 6.6 auf, durch die der Elektronenstrahl geführt werden kann.

Gegenüber dem bisherigen Betrieb des Elektronenmikroskops hat sich geändert, dass die auf den Elektronenstrahl als Linse wirkende stark gekrümmte Feldverteilung nicht mehr an den Rändern der Bohrung 6.6 durch den Grundkörper 6.1a entsteht, sondern am Übergang der Konzentratoren 6.1b zum VOI. Der Spalt zwischen dem Grundkörper 6.1a und den Konzentratoren 6.1b sollte möglichst klein sein, damit der magnetische Fluss optimal übertritt. Einige der magnetischen Feldlinien sind durch Pfeile angedeutet.

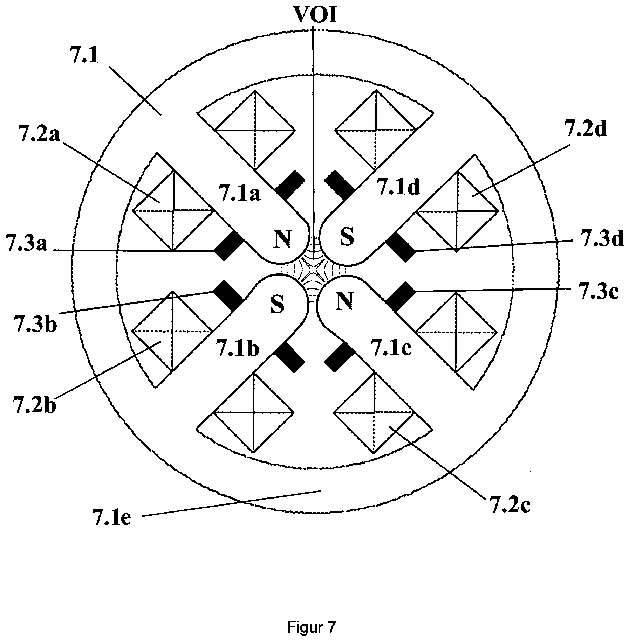

Figur 7 zeigt eine magnetische Quadrupollinse für ein Elektronenmikroskop als Ausführungsbeispiel der erfindungsgemäßen Vorrichtung in Schnittzeichnung. In das weichmagnetische Joch 7.1 werden von vier Spulen 7.2a, 7.2b, 7.2c und 7.2d magnetische Flüsse eingekoppelt. Diese werden von den vier Zweigen 7.1a, 7.1b, 7.1c und 7.1d des Jochs, die durch die Spulen 7.2a, 7.2b, 7.2c bzw. 7.2d geführt sind, jeweils ins Zentrum der Linse geführt, wo sich zwischen den Enden der vier Zweige das interessierende Volumen (VOI) befindet. Dieses Volumen wird mit einem Multipolfeld beaufschlagt. Alle vier Zweige 7.1a, 7.1b, 7.1c und 7.1d des Jochs münden in einen gemeinsamen Außenring 7.1e, über den sie miteinander verbunden sind.

Auf dem Weg von den Spulen 7.2a, 7.2b, 7.2c und 7.2d sind die vier Zweige 7.1a, 7.1b, 7.1c bzw. 7.1d des Jochs jeweils durch supraleitende Ringe 7.3a, 7.3b, 7.3c und 7.3d geführt, die im supraleitenden Zustand den Fluss konstant halten.

Analog zur Quadrupolanordnung in Figur 7 können auch höhere Multipole, etwa Sextupole oder Oktupole, realisiert werden.

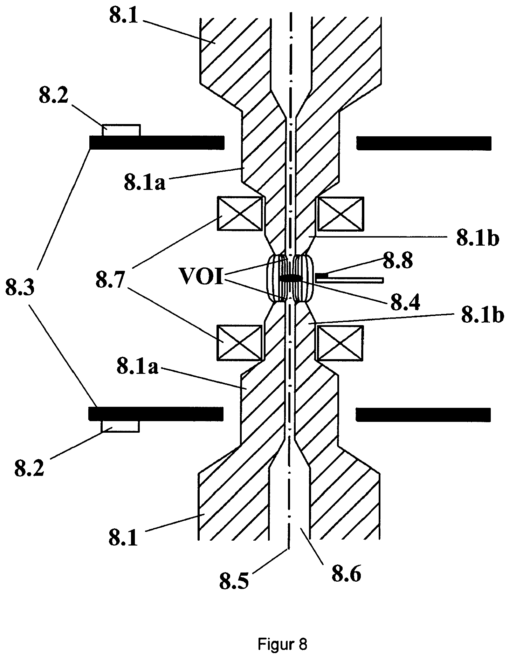

Figur 8 zeigt eine weitere Linse für ein Transmissionselektronenmikroskop als Ausführungsbeispiel der erfindungsgemäßen Vorrichtung in Schnittzeichnung. Auch in Figur 8 ist die Magnetfeldquelle aus Gründen der Übersichtlichkeit nicht eingezeichnet. Vom weichmagnetischen Joch 8.1 gehen die als Polschuhe ausgebildeten Bereiche 8.1a ab, die sich zu Bereichen 8.1b verengen und dort einen Spalt bilden.

Das interessierende Volumen VOI befindet sich dort, wo die Polschuhe 8.1b sich am nächsten gegenüberstehen. In diesem Volumen herrscht insbesondere an den Enden der Polschuhe 8.1b ein inhomogenes, als Linse wirkendes Magnetfeld, in deren Nähe sich die Probe 8.4 befindet. Die Probe 8.4 ist auf einem nicht eingezeichneten TEM-Probenhalter montiert.

Die Polschuhe 8.1a sind jeweils durch einen supraleitenden Ring 8.3 aus YBCO geführt. Zwischen diesem Ring 8.3 und dem VOI ist jeweils eine normalleitende oder supraleitende Korrekturspule 8.7 angeordnet. Beide Korrekturspulen 8.7 zusammen bilden ein auf einer Achse angeordnetes Spulenpaar, durch welches sich der magnetische Fluss im VOI auch im supraleitenden Zustand der Ringe 8.3 zumindest in einem kleinen Bereich verändern lässt. Dieses wirkt im VOI als ein Korrekturfeld beispielsweise für eine Fokusjustage in dem Elektronenmikroskop.

Im Bereich dieses Korrekturfeldes, aber am Rand oder außerhalb des VOI, ist ein Magnetfeldsensor 8.8 angeordnet. Wichtig für die Positionierung des Magnetfeldsensors ist nur, dass die Feldstärke am Ort des Magnetfeldsensors proportional zur Feldstärke im VOI ist. Der Magnetfeldsensor kann beispielsweise ein Hall-Sensor sein, aber auch ein Flusstransformator in Kombination mit einem abgeschirmten SQUID, an den der vom Flusstransformator empfangene magnetische Fluss übertragen wird. Der Magnetfeldsensor 8.8 kann in eine Rückkopplung mit den Korrekturspulen 8.7 geschaltet werden, um das Magnetfeld im VOI (beispielsweise für ein SQUID mit Flusstransformator als Magnetfeldsensor 8.8) bis auf einen Bruchteil 10⁻⁶ eines Flussquants Φ₀ konstant zu halten.

Die Linse ist rotationssymmetrisch zu einer Achse, die in Richtung des Hauptfelds durch das interessierende Volumen VOI führt. Diese Achse 8.5 entspricht beim Betrieb des Elektronenmikroskops der Strahlachse des Elektronenstrahls. Das Joch 8.1 weist Bohrungen 8.6 auf, durch die der Elektronenstrahl geführt werden kann.

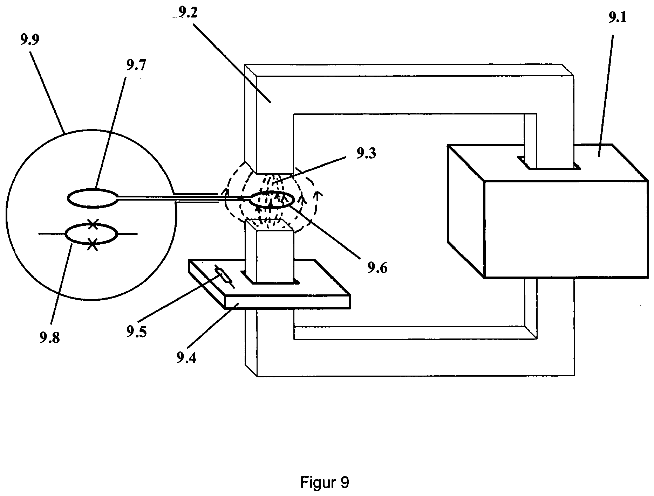

Figur 9 zeigt eine perspektivische Darstellung eines Versuchsaufbaus für eine "Proof of Concept"-Messung, die das Grundprinzip der Erfindung verdeutlicht. Das weichmagnetische Joch 9.2 hat eine zum Rechteck gebogene Form. Durch eine Spule 9.1 als Magnetfeldquelle wird ein magnetischer Fluss in dieses Joch 9.2 eingekoppelt. Das Joch 9.2 führt diesen Fluss in das interessierende Volumen (VOI) 9.3 und beaufschlagt dieses Volumen VOI 9.3 mit einem Magnetfeld. Einige der Feldlinien dieses Feldes sind zur Illustration in das VOI eingezeichnet.

Die Stärke des Magnetfelds im VOI 9.3 wird durch den magnetischen Fluss durch das Joch 9.2 bestimmt. Das Joch 9.2 ist in der Nähe eines Polschuhs von der supraleitenden Leiterschleife 9.4 umschlossen. Nachdem mit der Spule 9.1 das Magnetfeld im Volumen VOI eingestellt wurde, wird diese Leiterschleife 9.4 unter ihre Sprungtemperatur gekühlt und somit in den supraleitenden Zustand versetzt. Änderungen des magnetischen Flusses durch das Joch 9.2 werden fortan durch Induzierung eines Suprastroms entlang der Leiterschleife 9.4 kompensiert. Auf der supraleitenden Leiterschleife befindet sich ein Heizelement 9.5. Dieses erlaubt es die Leiterschleife wieder in den normalleitenden Zustand zu versetzen, um gegebenenfalls einer Änderung des magnetischen Flusses im VOI 9.3 vornehmen zu können.

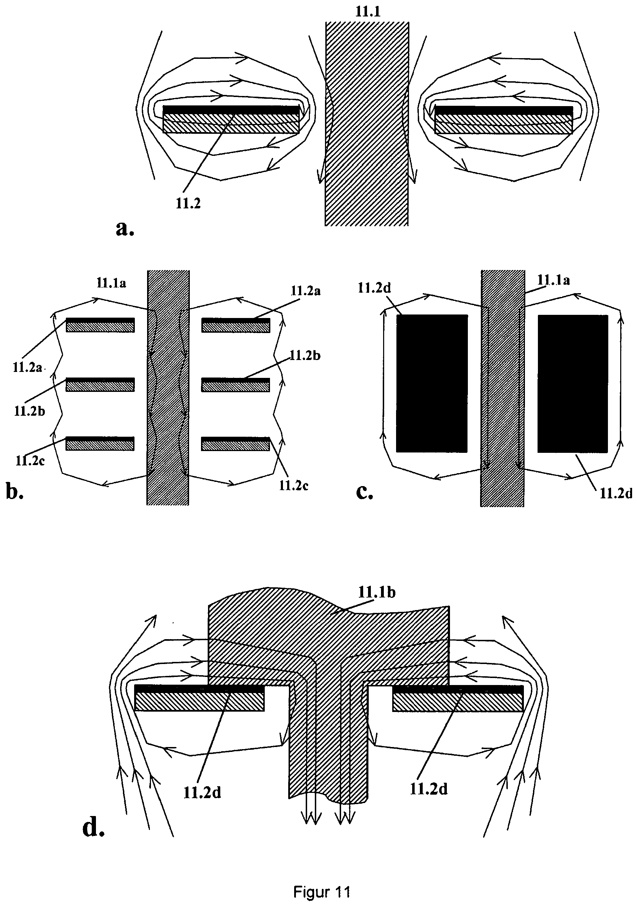

Die Magnetfeldstärke im VOI wird mit einem Magnetfeldsensor, welcher beispielweise aus einem Flusstransformator mit einer Einkoppelschleife 9.6 und einer Auskopplungsschleife 9.7 und mit einem SQUID 9.8 besteht, gemessen. Dabei befinden sich der SQUID und ein Teil des Flusstransformators in einer magnetischen Abschirmung 9.9. Von der Magnetfeldquelle 9.1 erzeigte Streufelder, welche nicht von den Polschuhenden am Spalt erzeugt werden, sondern direkt auf die Einkoppelschleife 9.6 wirken, können dazu führen, dass Störfelder nicht vollständig unterdrückt werden. Streufelder, die von Teilen des Jochs zwischen der Magnetfeldquelle 9.1 und dem supraleitenden Ring 9.4 ausgehen, können ebenfalls zu einer verminderten Störfeldabschirmung führen. Durch geeignete konstruktive Maßnahmen, wie beispielweise auch an Hand von Figur 11 diskutiert, lassen sich diese Effekte minimieren.

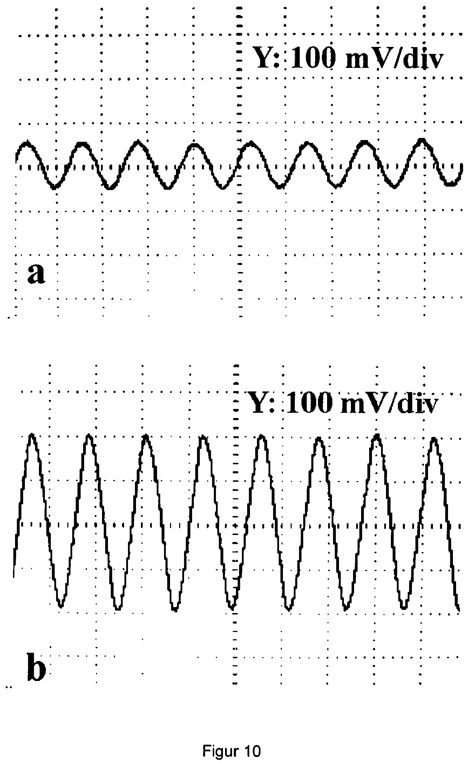

Figur 10 zeigt die Oszilloskop-Aufzeichnungen der "Proof of Concept"-Messung: a) Leiterschleife ist im supraleitenden Zustand und b) Leiterschleife ist im normalleitenden Zustand. Messung 10b zeigt die Antwort des SQUID-Detektors auf ein sinusförmiges Störsignal (ca. 80 Hz), welches über die magnetfelderzeugende Spule 9.1 eingekoppelt wurde, während der Heizer 9.5 angeschaltet war und sich die ringförmige Leiterschleife 9.4 somit im normalleitenden Zustand befand. Messung 10a zeigt die Antwort des SQUID auf das gleiche Störsignal nach Ausschalten des Heizers 9.5. Die vom SQUID registrierte Störsignalamplitude hat dabei gegenüber Messung 10b etwa um den Faktor 3 abgenommen.

Um die Effektivität der Störsignalunterdrückung zu erhöhen, ist des vorteilhaft, den Abstand zwischen dem weichmagnetischen Polschuh und dem ihn umgebenden supraleitenden Ring möglichst gering zu halten. Weiterhin ist es vorteilhaft, wenn die Dicke des supraleitenden Ringes möglichst groß ist, das heißt, er könnte aus einem Massivsupraleiter oder aus einem Stapel von Dünnschichtsupraleiterringen bestehen. Dieses ist in Figur 11 veranschaulicht.

Figur 11 zeigt die Verteilung des Magnetfeldes H zwischen supraleitender Leiterschleife und Permalloy Joch im Fall: a) einer Dünnschicht-Leiterschleife, b) mehrerer Dünnschicht-Leiterschleifen, c) einer massiven Leiterschleife oder d) einer Ausbuchtung am Joch. In den Teilbildern a), b) und d) ist die Leiterschleife jeweils eine dünne Schicht (schwarz dargestellt) auf einem normalleitenden oder isolierenden Substrat (schraffiert dargestellt).

Je größer der Abstand zwischen Leiterschleife und Joch, desto größer ist der Anteil des vom Suprastrom durch die Leiterschleife erzeugten Magnetfeldes, der durch den Spalt verläuft. Der zu diesem Anteil gehörende Fluss trägt nichts zur Kompensation von Flussänderungen im Joch 11.1 bei. Gleichzeitig ist an den Rändern der Leiterschleife 11.2 das lokale Magnetfeld umso größer, je dünner die Leiterschleife ist. Dadurch erhöht sich der Anteil des magnetischen Flusses der Leiterschleife, der durch den Spalt verläuft. Die Kompensation von Flussänderungen im Joch 11.1 wird dadurch weiter verschlechtert (Figur 11a). Bei sehr starker lokaler Felderhöhung am Rand der Leiterschleife 11.2 kann trotz der gegenüber dem Vakuum im Spalt wesentlich höheren relativen Permeabilität µᵣ des Jochs der Fluss im Spalt einen signifikanten Anteil des insgesamt durch die Leiterschleife hindurchtretenden Flusses (bis zu etwa 1/3) betragen.

Die Figur 11b zeigt, dass durch Anordnung mehrerer Leiterschleifen in einem Abstand, der höchstens der Breite der Leiterschleife entspricht, dieses Problem deutlich vermindert wird, indem das von den Leiterschleifen 11.2a, 11.2b und 11.2c ausgehende Magnetfeld im Inneren der von diesen Leiterschleifen gebildeten Stapelung homogenisiert wird. Es ist dann energetisch günstiger, wenn der Fluss frühzeitig in das Joch 11.1a eintritt und entlang der Stapelung innerhalb des Jochs 11.1a verläuft, wo der magnetische Widerstand wegen der hohen relativen Permeabilität µᵣ klein ist.

Figur 11c zeigt einen alternativen Weg auf, um hohe Flüsse im Spalt zu vermeiden. Hier wird das Feld im von der Leiterschleife 11.2d umschlossenen Bereich homogenisiert, indem diese entlang des Verlaufs des Jochs 11.1a wesentlich dicker als breit ist.

Figur 11d zeigt, wie ein Joch 11.1b mit einer Ausbuchtung hohe Flüsse im Spalt vermeidet. Die Ausbuchtung liegt auf der durch den Verlauf der Leiterschleife 11.2d im Raum definierten Fläche auf. Dadurch wird ein erheblicher Teil des von der Leiterschleife 11.2d erzeugten magnetischen Flusses, der entlang der Oberfläche der Leiterschleife verläuft, vor dem Eintritt in den Spalt durch das Joch 11.1b eingefangen.

## Patentansprüche

1. Vorrichtung zur Beaufschlagung eines interessierenden Volumens (VOI; 1,4; 2.4; 4.7; 9.3) mit einem konstanten Magnetfeld, umfassend mindestens eine Magnetfeldquelle (1.2; 2.2; 3.2a; 3.2b; 4.2; 7.2a; 7.2b; 7.2c; 7.2d; 9.1;) und ein permeables Joch (1.1; 2.1; 3.1; 4.1; 5.1; 6.1; 7.1; 8.1; 9.2; 11.1), das den von dieser Magnetfeldquelle erzeugten magnetischen Fluss in das interessierende Volumen (VOI; 1,4; 2.4; 4.7; 9.3) führt, wobei das Joch (1.1; 2.1; 3.1; 4.1; 5.1; 6.1; 7.1; 8.1; 9.2; 11.1) durch mindestens eine geschlossene Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) geführt ist wobei die Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) zwischen der Magnetfeldquelle (1.2; 2.2; 3.2a; 3.2b; 4.2; 7.2a; 7.2b; 7.2c; 7.2d; 9.1) und dem interessierenden Volumen (VOI; 1,4; 2.4; 4.7; 9.3) angeordnet ist und wobei
die Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) in den supraleitenden Zustand überführbar ist, so dass im supraleitenden Zustand der Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) eine Änderung des Flusses durch das Joch (1.1; 2.1; 3.1; 4.1; 5.1; 6.1; 7.1; 8.1; 9.2; 11.1) einen dieser Änderung entgegenwirkenden Strom entlang der Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) bewirkt, **dadurch gekennzeichnet, dass** Schaltmittel (2.7; 9.5) zur lokalen Umschaltung eines Teils der mindestens einen Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) vom supraleitenden in den normalleitenden Zustand vorgesehen sind, wobei die Schaltmittel
• mindestens einen Josephson-Kontakt und/oder
• ein Heizelement und/oder
• eine elektromagnetische Strahlungsquelle zur lokalen Erwärmung der Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) und/oder
• eine lokale Leiterquerschnittsverengung mit reduziertem kritischen Strom auf dem Umfang der Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d), durch welche beim Übergang in den normalleitenden Zustand ein magnetischer Fluss in die Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) eindringen kann,
umfassen.

2. Vorrichtung nach Anspruch 1, **dadurch gekennzeichnet, dass** die Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) entlang des Jochs (1.1; 2.1; 3.1; 4.1; 5.1; 6.1; 7.1; 8.1; 9.2; 11.1) zwischen einem Ort, an dem unerwünschte Schwankungen dem Fluss durch das Joch (1.1; 2.1; 3.1; 4.1; 5.1; 6.1; 7.1; 8.1; 9.2; 11.1) vorwiegend aufgeprägt werden, und dem interessierenden Volumen (VOI; 1,4; 2.4; 4.7; 9.3) angeordnet ist.

3. Vorrichtung nach einem der Ansprüche 1 bis 2, **dadurch gekennzeichnet, dass** die Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) im Bereich eines jeden Übergangs zwischen dem interessierenden Volumen (VOI; 1,4; 2.4; 4.7; 9.3) und dem Joch (1.1; 2.1; 3.1; 4.1; 5.1; 6.1; 7.1; 8.1; 9.2; 11.1) angeordnet ist.

4. Vorrichtung nach einem der Ansprüche 1 bis 3, **dadurch gekennzeichnet, dass** die Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) an einem Ort angeordnet ist, an dem das von der Magnetfeldquelle (1.2; 2.2; 3.2a; 3.2b; 4.2; 7.2a; 7.2b; 7.2c; 7.2d; 9.1) ausgehende Magnetfeld höchstens ein Zehntel, bevorzugt höchstens ein Hundertstel und ganz besonders bevorzugt höchstens ein Tausendstel seiner maximalen Feldstärke hat.

5. Vorrichtung nach einem der Ansprüche 1 bis 4, **dadurch gekennzeichnet, dass** das Joch (1.1; 2.1; 3.1; 4.1; 5.1; 6.1; 7.1; 8.1; 9.2; 11.1) auf jedem von einer Magnetfeldquelle (1.2; 2.2; 3.2a; 3.2b; 4.2; 7.2a; 7.2b; 7.2c; 7.2d; 9.1) zum interessierenden Volumen (VOI; 1,4; 2.4; 4.7; 9.3) führenden Weg durch mindestens eine Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) geführt ist.

6. Vorrichtung nach einem der Ansprüche 1 bis 5, **dadurch gekennzeichnet, dass** mindestens eine Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) an einem Ort entlang des Jochs (1.1; 2.1; 3.1; 4.1; 5.1; 6.1; 7.1; 8.1; 9.2; 11.1) angeordnet ist, an dem die vom Joch (1.1; 2.1; 3.1; 4.1; 5.1; 6.1; 7.1; 8.1; 9.2; 11.1) ausgehende Streufeldstärke höchstens ein Fünftel, bevorzugt höchstens ein Zehntel und ganz besonders bevorzugt höchstens ein Hundertstel der maximalen magnetischen Feldstärke im interessierenden Volumen (VOI; 1,4; 2.4; 4.7; 9.3) beträgt.

7. Vorrichtung nach einem der Ansprüche 1 bis 6, **dadurch gekennzeichnet, dass** das Material des Jochs (1.1; 2.1; 3.1; 4.1; 5.1; 6.1; 7.1; 8.1; 9.2; 11.1) eine relative Permeabilität µᵣ von mindestens 10, bevorzugt von mindestens 100, aufweist.

8. Vorrichtung nach einem der Ansprüche 1 bis 7, **dadurch gekennzeichnet, dass** die mindestens eine Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) als Schicht auf einem Substrat realisiert ist, das entweder überhaupt nicht oder erst bei einer tieferen Sprungtemperatur als die Schicht in den supraleitenden Zustand übergeht.

9. Vorrichtung nach einem der Ansprüche 1 bis 8, **dadurch gekennzeichnet, dass** die Magnetfeldquelle (1.2; 2.2; 3.2a; 3.2b; 4.2; 7.2a; 7.2b; 7.2c; 7.2d; 9.1;), das Joch (1.1; 2.1; 3.1; 4.1; 5.1; 6.1; 7.1; 8.1; 9.2; 11.1) und die mindestens eine Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) um eine Achse (1.5; 4.5; 5.5; 6.5; 8.5), die das interessierende Volumen (VOI; 1,4; 2.4; 4.7; 9.3) durchdringt, rotationssymmetrisch aufgebaut sind.

10. Vorrichtung nach einem der Ansprüche 1 bis 9, **dadurch gekennzeichnet, dass** die mindestens eine Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) aus einem hochtemperatursupraleitenden Material, insbesondere aus einem solchen auf YBCO-Basis, besteht.

11. Vorrichtung nach einem der Ansprüche 1 bis 10, **dadurch gekennzeichnet, dass** entlang des Jochs (1.1; 2.1; 3.1; 4.1; 5.1; 6.1; 7.1; 8.1; 9.2; 11.1) zwischen der mindestens einen Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) und dem interessierenden Volumen (VOI; 1,4; 2.4; 4.7; 9.3) mindestens eine separat mit einem Strom beaufschlagbare Korrekturspule (8.7) angeordnet ist.

12. Vorrichtung nach Anspruch 11, **dadurch gekennzeichnet, dass** Mittel zur Messung einer von der Korrekturspule (8.7) ausgehenden magnetischen Feldstärke sowie eine Rückkoppelschleife vorgesehen sind, wobei die Rückkoppelschleife die gemessene Feldstärke als Eingabe erhält und den Strom durch die Korrekturspule (8.7) regelt.

13. Vorrichtung nach einem der Ansprüche 1 bis 12, **dadurch gekennzeichnet, dass** das Joch (1.1; 2.1; 3.1; 4.1; 5.1; 6.1; 7.1; 8.1; 9.2; 11.1) durch mindestens zwei Leiterschleifen (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) geführt ist, die entlang des Jochs (1.1; 2.1; 3.1; 4.1; 5.1; 6.1; 7.1; 8.1; 9.2; 11.1) in einem Abstand zueinander angeordnet sind, der höchstens ihrer Breite entspricht.

14. Vorrichtung nach Anspruch 13, **dadurch gekennzeichnet, dass** der Abstand mindestens genauso groß ist wie der kürzeste Abstand zwischen der Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) und dem Joch (1.1; 2.1; 3.1; 4.1; 5.1; 6.1; 7.1; 8.1; 9.2; 11.1).

15. Vorrichtung nach einem der Ansprüche 1 bis 14, **dadurch gekennzeichnet, dass** die Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) mindestens so dick wie breit ist.

16. Vorrichtung nach einem der Ansprüche 1 bis 15, **dadurch gekennzeichnet, dass** das Joch (1.1; 2.1; 3.1; 4.1; 5.1; 6.1; 7.1; 8.1; 9.2; 11.1) eine Ausbuchtung aufweist, die
• auf der durch den Verlauf der Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) im Raum definierten Fläche aufliegt und/oder
• durch einen Spalt von dieser Fläche getrennt ist, wobei die Ausbuchtung sich in den Bereich erstreckt, in dem das durch die Leiterschleife (1.3; 2.3; 3.5a; 3.5b; 4.3; 5.3a; 5.3b; 6.3; 7.3a; 7.3b; 7.3c; 7.3d; 8:3; 9.4; 11.2; 11.2a; 11.2b; 11.2c; 11.2d) erzeugte Magnetfeld mindestens 50 % seiner maximalen Stärke auf der Fläche aufweist.

17. Verwendung einer Vorrichtung nach einem der Ansprüche 1 bis 16
• als magnetische Linse in einem Elektronenmikroskop,
• zur Stabilisierung eines Magnetfelds, mit dem eine Probe bei einer Messung der kernmagnetischen Resonanz (NMR) beaufschlagt wird,
• zur Stabilisierung eines Magnetfelds in einer Teilchenfalle oder
• zur Stabilisierung des Magnetfelds eines Strahlführungs- oder Detektormagneten in einem Teilchenbeschleuniger.

18. Verfahren zum Betreiben einer Vorrichtung nach einem der Ansprüche 1 bis 16,
**dadurch gekennzeichnet, dass**
mit der Magnetfeldquelle (1.2; 2.2; 3.2a; 3.2b; 4.2; 7.2a; 7.2b; 7.2c; 7.2d; 9.1;) der Fluss durch das Joch (1.1; 2.1; 3.1; 4.1; 5.1; 6.1; 7.1; 8.1; 9.2; 11.1) eingestellt wird, während die Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) sich im normalleitenden Zustand befindet, und dass die Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) anschließend in den supraleitenden Zustand überführt wird, um den Fluss konstant zu halten.

19. Verfahren zum Betreiben einer Vorrichtung nach einem der Ansprüche 1 bis 16,
**dadurch gekennzeichnet, dass**
• mit der Magnetfeldquelle (1.2; 2.2; 3.2a; 3.2b; 4.2; 7.2a; 7.2b; 7.2c; 7.2d; 9.1;) der Fluss durch das Joch (1.1; 2.1; 3.1; 4.1; 5.1; 6.1; 7.1; 8.1; 9.2; 11.1) eingestellt wird, während die Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) sich im supraleitenden Zustand befindet, so dass die Flussänderung in einen Suprastrom durch die Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) umgewandelt wird;
• die Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) anschließend zumindest an einer Stelle in den normalleitenden Zustand überführt wird, um den Suprastrom in eine Änderung des Magnetfelds im interessierenden Volumen (VOI; 1,4; 2.4; 4.7; 9.3) umzuwandeln;
• die Leiterschleife (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) anschließend in den supraleitenden Zustand zurückversetzt wird, um das Magnetfeld im interessierenden Volumen (VOI; 1,4; 2.4; 4.7; 9.3) auf dem neuen Niveau konstant zu halten.

## Claims

1. A device for loading a volume of interest (VOI; 1,4; 2.4; 4.7; 9.3) with a constant magnetic field, comprising at least one magnetic field source (1.2; 2.2; 3.2a; 3.2b; 4.2; 7.2a; 7.2b; 7.2c; 7.2d; 9.1;) and a permeable yoke (1.1; 2.1; 3.1; 4.1; 5.1; 6.1; 7.1; 8.1; 9.2; 11.1) which guides the magnetic flux generated by this magnetic field source into the volume of interest (VOI; 1,4; 2.4; 4.7; 9.3), wherein the yoke (1.1; 2.1; 3.1; 4.1; 5.1; 6.1; 7.1; 8.1; 9.2; 11.1) is guided through at least one closed conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d), wherein the conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b, 11.2c; 11.2d) is arranged between the magnetic field source (1.2; 2.2; 3.2a; 3.2b; 4.2; 7.2a; 7.2b; 7.2c; 7.2d; 9.1) and the volume of interest (VOI; 1,4; 2.4; 4.7; 9.3), and wherein the conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) can be transferred into the superconducting state in such a way that, in the superconducting state of the conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d), a change of the flux by the yoke (1.1; 2.1; 3.1; 4.1; 5.1; 6.1; 7.1; 8.1; 9.2; 11.1) causes a current along the conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d), which current counteracts this change, **characterized in that** switching means (2.7; 9.5) are provided for local switching of a part of the at least one conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) from the superconducting to the normally conducting state, wherein the switching means comprise
• at least one Josephson contact and/or
• a heating element and/or
• an electromagnetic radiation source for local heating of the conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) and/or
• a local conductor cross-section narrowing with reduced critical current on the circumference of the conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d), through which a magnetic flux, during the transition to the normally conducting state, is able to penetrate the conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d)

2. A device according to claim 1, **characterized in that** the conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) along the yoke (1.1; 2.1; 3.1; 4.1; 5.1; 6.1; 7.1; 8.1; 9.2; 11.1) is arranged between a location, at which undesired fluctuations are predominantly impressed on the flux through the yoke (1.1; 2.1; 3.1; 4.1; 5.1; 6.1; 7.1; 8.1; 9.2; 11.1), and the volume of interest (VOI; 1,4; 2.4; 4.7; 9.3).

3. A device according to any one of claims 1 to 2, **characterized in that** the conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) is arranged in the region of each transition between the volume of interest (VOI; 1,4; 2.4; 4.7; 9.3) and the yoke (1.1; 2.1; 3.1; 4.1; 5.1; 6.1; 7.1; 8.1; 9.2; 11.1).

4. A device according to any one of claims 1 to 3, **characterized in that** the conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) is arranged at a location at which the magnetic field emanating from the magnetic field source (1.2; 2.2; 3.2a; 3.2b; 4.2; 7.2a; 7.2b; 7.2c; 7.2d; 9.1) has at most one tenth, preferably at most one hundredth and very particularly preferably at most one thousandth of its maximum field strength.

5. A device according to any one of claims 1 to 4, **characterized in that** the yoke (1.1; 2.1; 3.1; 4.1; 5.1; 6.1; 7.1; 8.1; 9.2; 11.1), on each path leading from a magnetic field source (1.2; 2.2; 3.2a; 3.2b; 4.2; 7.2a; 7.2b; 7.2c; 7.2d; 9.1) to the volume of interest (VOI; 1,4; 2.4; 4.7; 9.3), is guided through at least one conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d).

6. A device according to any one of claims 1 to 5, **characterized in that** at least one conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) is arranged at a location along the yoke (1.1; 2.1; 3.1; 4.1; 5.1; 6.1; 7.1; 8.1; 9.2; 11.1), at which the stray field strength emanating from the yoke (1.1; 2.1; 3.1; 4.1; 5.1; 6.1; 7.1; 8.1; 9.2; 11.1), is at most one fifth, preferably at most one tenth and very particularly preferably at most one hundredth of the maximum magnetic field strength in the volume of interest (VOI; 1,4; 2.4; 4.7; 9.3).

7. A device according to any one of claims 1 to 6, **characterized in that** the material of the yoke (1.1; 2.1; 3.1; 4.1; 5.1; 6.1; 7.1; 8.1; 9.2; 11.1) has a relative permeability µᵣ of at least 10, preferably of least 100.

8. A device according to any one of claims 1 to 7, **characterized in that** the at least one conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) is realized as layer on a substrate, which either does not change to the superconducting state at all or only changes to the superconducting state at a lower transition temperature than the layer.

9. A device according to any one of claims 1 bis 8, **characterized in that** the magnetic field source (1.2; 2.2; 3.2a; 3.2b; 4.2; 7.2a; 7.2b; 7.2c; 7.2d; 9.1;), the yoke (1.1; 2.1; 3.1; 4.1; 5.1; 6.1; 7.1; 8.1; 9.2; 11.1) and the at least one conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) are constructed so as to be rotationally symmetrical about an axis (1.5; 4.5; 5.5; 6.5; 8.5) which penetrates the volume of interest (VOI; 1,4; 2.4; 4.7; 9.3).

10. A device according to any one of claims 1 to 9, **characterized in that** the at least one conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) consists of a high-temperature superconducting material, said material, in particular, being based on YBCO.

11. A device according to any one of claims 1 to 10, **characterized in that** at least one correction coil (8.7) capable of being separately loaded with a current is arranged along the yoke (1.1; 2.1; 3.1; 4.1; 5.1; 6.1; 7.1; 8.1; 9.2; 11.1) between the at least one conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) and the volume of interest (VOI; 1,4; 2.4; 4.7; 9.3).

12. A device according to claim 11, **characterized in that** means for measuring a magnetic field strength emanating from the correction coil (8.7) as well as a feedback loop are provided, wherein the feedback loop receives the measured field strength as input and regulates the current through the correction coil (8.7).

13. A device according to any one of claims 1 to 12, **characterized in that** the yoke (1.1; 2.1; 3,1; 4.1; 5.1; 6.1; 7.1; 8.1; 9.2; 11.1) is guided through at least two conductor loops (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d), which, along the yoke (1.1; 2.1; 3.1; 4.1; 5.1; 6.1; 7.1; 8.1; 9.2; 11.1), are arranged at a distance from one another, which at most corresponds to their width.

14. A device according to claim 13, **characterized in that** the distance is at least as great as the shortest distance between the conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) and the yoke (1.1; 2.1; 3.1; 4.1; 5.1; 6.1; 7,1; 8.1; 9.2; 11.1).

15. A device of any one of claims 1 to 14, **characterized in that** the conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) is at least as thick as it is wide.

16. A device according to any one of claims 1 to 15, **characterized in that** the yoke (1.1; 2.1; 3.1; 4.1; 5.1; 6.1; 7.1; 8.1; 9.2; 11.1) has a bulge which rests
• on the surface defined by the course of the conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) in the space and/or
• is separated from this surface by a gap, wherein the bulge extends into the region in which the magnetic field generated by the conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) has at least 50% of its maximum strength on the surface.

17. A use of a device according to any one of claims 1 to 16
• as magnetic lens in an electron microscope,
• for stabilizing a magnetic field with which a sample is loaded when measuring the nuclear magnetic resonance (NMR),
• for stabilizing a magnetic field in a particle trap or
• for stabilizing the magnetic field of a beam guiding or detector magnet in a particle accelerator.

18. A method for operating a device according to any one of claims 1 to 16, **characterized in that**,
with the magnetic field source (1.2; 2.2; 3.2a; 3.2b; 4.2; 7.2a; 7.2b; 7.2c; 7.2d; 9.1;), the flux is set by means of the yoke (1.1; 2.1; 3.1; 4.1; 5.1; 6.1; 7.1; 8.1; 9.2; 11.1), while the conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) is in the normally conducting state and that the conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) is then transferred into the superconducting state for the purpose of keeping the flux constant.

19. A method for operating a device according to any one of claims 1 to 16, **characterized in that**,
• with the magnetic field source (1.2; 2.2; 3.2a; 3.2b; 4.2; 7.2a; 7.2b; 7.2c; 7.2d; 9.1;), the flux is set by means of the yoke (1.1; 2.1; 3.1; 4.1; 5.1; 6.1; 7.1; 8.1; 9.2; 11.1), while the conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) is in the superconducting state so that the flux change is converted into a supercurrent through the conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d);
• the conductor loop (1.3; 2.3; 3.5a; 3.5b; 4.3; 5.3a; 5.3b; 6.3; 7.3a; 7.3b; 7.3c; 7.3d; 8.3; 9.4; 11.2; 11.2a; 11.2b; 11.2c; 11.2d) is then transferred, at least at one point, into the normally conducting state for the purpose of converting the supercurrent into a change of the magnetic field in the volume of interest (VOI; 1,4; 2.4; 4.7; 9.3);
• the conductor loop (1.3; 2.3; 3.5a; 3.5b; 4.3; 5.3a; 5.3b; 6.3; 7.3a; 7.3b; 7.3c; 7.3d; 8.3; 9,4; 11.2; 11.2a; 11.2b; 11.2c; 11.2d) is then reset into the superconducting state for the purpose of keeping the magnetic field in the volume of interest (VOI; 1,4; 2.4; 4.7; 9.3) constant at the new level.

## Revendications

1. Installation pour soumettre un volume (VOl ; 1,4 ; 2.4 ; 4.7 ; 9.3) auquel on s'intéresse à un champ magnétique constant, comprenant au moins une source (1.2 ; 2.2 ; 3.2a ; 3.2b ; 4.2 ; 7.2a ; 7.2b ; 7.2c ; 7.2d ; 9.1) de champs magnétique et une culasse (1.1 ; 2.1 ; 3.1 ; 4.1 ; 5.1 ; 6.1 ; 7.1 ; 8.1 ; 9.2 ; 11.1) perméable, qui conduit, dans le volume (VOl ; 1,4 ; 2.4 ; 4.7 ; 9.3) auquel on s'intéresse, le flux magnétique produit par cette source de champ magnétique, dans laquelle la culasse (1.1 ; 2.1 ; 3.1 ; 4.1 ; 5.1 ; 6.1 ; 7.1 ; 8.1 ; 9.2 ; 11.1) est guidée par au moins une boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a ; 11.2b ; 11.2c ; 11.2d) conductrice fermée, la boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a, 11.2b ; 11.2c ; 11.2d) conductrice étant disposée entre la source (1.2 ; 2.2 ; 3.2a ; 3.2b ; 4.2 ; 7.2a ; 7.2b ; 7.2c ; 7.2d ; 9.1) de champ magnétique et le volume (VOl ; 1,4 ; 2.4 ; 4.7 ; 9.3) auquel on s'intéresse
et dans laquelle
la boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a, 11.2b ; 11.2c ; 11.2d) conductrice peut passer dans l'état supraconducteur de sorte que, dans l'état supraconducteur de la boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a, 11.2b ; 11.2c ; 11.2d) conductrice, une variation du flux dans la culasse (1.1 ; 2.1 ; 3.1 ; 4.1 ; 5.1 ; 6.1 ; 7.1 ; 8.1 ; 9.2 ; 11.1) provoque un courant, s'opposant à cette variation, le long de la boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a, 11.2b ; 11.2c ; 11.2d) conductrice, **caractérisée en ce qu'**il est prévu des moyens (2.7 ; 9.5) de commutation locale d'une partie de la au moins une boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a, 11.2b ; 11.2c ; 11.2d) conductrice de l'état supraconducteur à l'état conducteur normal, dans laquelle les moyens de commutation comprennent
• au moins un contact Josephson et/ou
• un élément chauffant et/ou
• une source de rayonnement électromagnétique pour l'échauffement local de la boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a ; 11.2b ; 11.2c ; 11.2d) conductrice et/ou
• un rétrécissement local de la section transversale conductrice avec courant critique réduit sur le pourtour de la boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a ; 11.2b ; 11.2c ; 11.2d) conductrice, par lequel, lors du passage dans l'état conducteur normal, un flux magnétique peut pénétrer dans la boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a ; 11.2b ; 11.2c ; 11.2d) conductrice.

2. Installation suivant la revendication 1, **caractérisée en ce que** la boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a ; 11.2b ; 11.2c ; 11.2d) conductrice est disposée le long de la culasse (1.1 ; 2.1 ; 3.1 ; 4.1 ; 5.1 ; 6.1 ; 7.1 ; 8.1 ; 9.2 ; 11.1) entre un emplacement, où des fluctuations non souhaitées sont imprimées de manière prépondérante au flux dans la culasse (1.1 ; 2.1 ; 3.1 ; 4.1 ; 5.1 ; 6.1 ; 7.1 ; 8.1 ; 9.2 ; 11.1), et le volume (VOl ; 1.4 ; 2.4 ; 4.7 ; 9.3) auquel on s'intéresse.

3. Installation suivant l'une des revendications 1 à 2, **caractérisée en ce que** la boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a ; 11.2b ; 11.2c ; 11.2d) conductrice est disposée dans la partie d'une transition entre le volume (VOl ; 1,4 ; 2.4 ; 4.7 ; 9.3) auquel on s'intéresse et la culasse (1.1 ; 2.1 ; 3.1 ; 4.1 ; 5.1 ; 6.1 ; 7.1 ; 8.1 ; 9.2 ; 11.1).

4. Installation suivant l'une des revendications 1 à 3, **caractérisée en ce que** la boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a ; 11.2b ; 11.2c ; 11.2d) conductrice est disposée en un emplacement, où le champ magnétique provenant de la source (1.2 ; 2.2 ; 3.2a ; 3.2b ; 4.2 ; 7.2a ; 7.2b ; 7.2c ; 7.2d ; 9.1) magnétique a au plus un dixième, de préférence au plus un centième, et d'une manière particulièrement préférée au plus un millième, de son intensité maximum.

5. Installation suivant l'une des revendications 1 à 4, **caractérisée en ce que** la culasse (1.1 ; 2.1 ; 3.1 ; 4.1 ; 5.1 ; 6.1 ; 7.1 ; 8.1 ; 9.2 ; 11.1) est guidée par au moins une boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a ; 11.2b ; 11.2c ; 11.2d) conductrice sur chaque chemin menant d'une source (1.2 ; 2.2 ; 3.2a ; 3.2b ; 4.2 ; 7.2a ; 7.2b ; 7.2c ; 7.2d ; 9.1)de champ magnétique au volume (VOl ; 1,4 ; 2.4 ; 4.7 ; 9.3) auquel on s'intéresse.

6. Installation suivant l'une des revendications 1 à 5, **caractérisée en ce qu'**au moins une boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a ; 11.2b ; 11.2c ; 11.2d) conductrice est disposée en un emplacement le long de la culasse (1.1 ; 2.1 ; 3.1 ; 4.1 ; 5.1 ; 6.1 ; 7.1 ; 8.1 ; 9.2 ; 11.1) où l'intensité du champ de dispersion provenant de la culasse (1.1 ; 2.1 ; 3.1 ; 4.1 ; 5.1 ; 6.1 ; 7.1 ; 8.1 ; 9.2 ; 11.1) représente au plus un cinquième, de préférence au plus un dixième, et d'une manière particulièrement préférée au plus un centième de l'intensité du champ magnétique maximum dans le volume (VOl ; 1.4 ; 2.4 ; 4.7 ; 9.3) auquel on s'intéresse.

7. Installation suivant l'une des revendications 1 à 6, **caractérisée en ce que** le matériau de la culasse(1.1 ; 2.1 ; 3.1 ; 4.1 ; 5.1 ; 6.1 ; 7.1 ; 8.1 ; 9.2 ; 11.1) a une perméabilité µᵣ relative d'au moins 10, de préférence d'au moins 100.

8. Installation suivant l'une des revendications 1 à 7, **caractérisée en ce que** la au moins une boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a, 11.2b ; 11.2c ; 11.2d) conductrice est réalisée sous la forme d'une couche sur un substrat, qui soit ne passe absolument pas à l'état supraconducteur, ou n'y passe qu'à une température de transition plus basse que la couche.

9. Installation suivant l'une des revendications 1 à 8, **caractérisée en ce que** la source (1.2 ; 2.2 ; 3.2a ; 3.2b ; 4.2 ; 7.2a ; 7.2b ; 7.2c ; 7.2d ; 9.1) de champ magnétique, la culasse (1.1 ; 2.1 ; 3.1 ; 4.1 ; 5.1 ; 6.1 ; 7.1 ; 8.1 ; 9.2 ; 11.1) et la au moins une boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a ; 11.2b ; 11.2c ; 11.2d) conductrice sont de révolution autour d'un axe (1.5 ; 4.5 ; 5.5 ; 6.5 ; 8.5), qui traverse le volume (VOl ; 1.4 ; 2.4 ; 4.7 ; 9.3) auquel on s'intéresse.

10. Installation suivant l'une des revendications 1 à 9, **caractérisée en ce que** la au moins une boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a ; 11.2b ; 11.2c ; 11.2d) conductrice est en un matériau supraconducteur à haute température, notamment en un matériau de ce genre, à base d'YBCO.

11. Installation suivant l'une des revendications 1 à 10, **caractérisée en ce qu'**au moins une bobine (8.7) de correction, pouvant être alimentée de manière séparée en un courant, est disposée le long de la culasse (1.1 ; 2.1 ; 3.1 ; 4.1 ; 5.1 ; 6.1 ; 7.1 ; 8.1 ; 9.2 ; 11.1) entre la au moins une boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a ; 11.2b ; 11.2c ; 11.2d) conductrice et le volume (VOl ; 1.4 ; 2.4 ; 4.7 ; 9.3) auquel on s'intéresse.

12. Installation suivant la revendication 11, **caractérisée en ce qu'**il est prévu des moyens de mesure d'une intensité du champ magnétique provenant de la bobine (8.7) de correction, ainsi qu'une boucle de réaction, la boucle de réaction obtenant comme entrée l'intensité du champ mesurée et réglant le courant dans la bobine (8.7) de correction.

13. Installation suivant l'une des revendications 1 à 12, **caractérisée en ce que** la culasse (1.1 ; 2.1 ; 3.1 ; 4.1 ; 5.1 ; 6.1 ; 7.1 ; 8.1 ; 9.2 ; 11.1) est guidée par au moins deux boucles (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a ; 11.2b ; 11.2c ; 11.2d) conductrices, qui sont disposées le long de la culasse (1.1 ; 2.1 ; 3.1 ; 4.1 ; 5.1 ; 6.1 ; 7.1 ; 8.1 ; 9.2 ; 11.1) à une distance les unes des autres, qui correspond au plus à leur largeur.

14. Installation suivant la revendication 13, **caractérisée en ce que** la distance est au moins exactement aussi grande que la distance la plus courte entre les boucles (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a ; 11.2b ; 11.2c ; 11.2d) conductrices et la culasse (1.1 ; 2.1 ; 3.1 ; 4.1 ; 5.1 ; 6.1 ; 7.1 ; 8.1 ; 9.2 ; 11.1).

15. Installation suivant l'une des revendications 1 à 14, **caractérisée en ce que** la boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a ; 11.2b ; 11.2c ; 11.2d) conductrice est au moins aussi épaisse que large.

16. Installation suivant l'une des revendications 1 à 15, **caractérisée en ce que** la culasse (1.1 ; 2.1 ; 3.1 ; 4.1 ; 5.1 ; 6.1 ; 7.1 ; 8.1 ; 9.2 ; 11.1) a une bosse sortante, qui
• s'applique sur la surface définie dans l'espace par le tracé de la boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a ; 11.2b ; 11.2c ; 11.2d) conductrice et/ou
• est séparée de cette surface par une fente, la bosse sortante s'étendant dans la partie dans laquelle le champ magnétique, produit par la boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a ; 11.2b ; 11.2c ; 11.2d) conductrice, a au moins 50% de son intensité maximum sur la surface .

17. Utilisation d'une installation suivant l'une des revendications 1 à 16,
• comme lentille magnétique dans un microscope électronique,
• pour la stabilisation d'un champ magnétique, auquel est soumis un échantillon lors d'une mesure de la résonnance magnétique nucléaire (RMN),
• pour la stabilisation d'un champ magnétique d'un piège à particules ou
• pour la stabilisation du champ magnétique d'un aimant de guidage de faisceau ou de détecteur de faisceau d'un accélérateur de particules.

18. Procédé pour faire fonctionner une installation suivant l'une des revendications 1 à 16, **caractérisé en ce que**
on règle par la source (1.2 ; 2.2 ; 3.2a ; 3.2b ; 4.2 ; 7.2a ; 7.2b ; 7.2c ; 7.2d ; 9.1) de champ magnétique le flux dans la culasse (1.1 ; 2.1 ; 3.1 ; 4.1 ; 5.1 ; 6.1 ; 7.1 ; 8.1 ; 9.2 ; 11.1), tandis que la boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a ; 11.2b ; 11.2c ; 11.2d) conductrice se trouve dans l'état conducteur normal et **en ce que** l'on fait passer la boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a ; 11.2b ; 11.2c ; 11.2d) conductrice ensuite dans l'état supraconducteur pour maintenir le flux constant.

19. Procédé pour faire fonctionner une installation suivant l'une des revendications 1 à 16, **caractérisé en ce que**
• par la source (1.2 ; 2.2 ; 3.2a ; 3.2b ; 4.2 ; 7.2a ; 7.2b ; 7.2c ; 7.2d ; 9.1) de champ magnétique on règle le flux dans la culasse (1.1; 2.1 ; 3.1 ; 4.1 ; 5.1 ; 6.1 ; 7.1 ; 8.1 ; 9.2 ; 11.1), tandis que la boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a ; 11.2b ; 11.2c ; 11.2d) conductrice se trouve dans l'état supraconducteur de manière à transformer la variation de flux en un courant supraconducteur dans la bobine (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a ; 11.2b ; 11.2c ; 11.2d) conductrice ;
• on fait passer ensuite au moins en un emplacement la boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a ; 11.2b ; 11.2c ; 11.2d) conductrice dans l'état conducteur normal pour transformer le courant supraconducteur en une variation du champ magnétique dans le volume (VOl ; 1.4 ; 2.4 ; 4.7 ; 9.3) auquel on s'intéresse ;
• on remet ensuite la boucle (1.3 ; 2.3 ; 3.5a ; 3.5b ; 4.3 ; 5.3a ; 5.3b ; 6.3 ; 7.3a ; 7.3b ; 7.3c ; 7.3d ; 8.3 ; 9.4 ; 11.2 ; 11.2a ; 11.2b ; 11.2c ; 11.2d) conductrice dans l'état supraconducteur pour maintenir constant au nouveau niveau le champ magnétique dans le volume (VOl ; 1.4 ; 2.4 ; 4.7 ; 9.3) auquel on s'intéresse.
